# EUROPEAN PATENT APPLICATION

(11) **EP 1 592 050 A1**
(43) Date of publication of application: **02.11.2005**
(21) Application number: 03815744.2
(22) Date of filing: 20.11.2003
(51) Int. Cl.: H01L 21/308, H05B 33/26, G02F 1/1343

(54) **METHOD FOR MANUFACTURING SEMI-TRANSPARENT SEMI-REFLECTIVE ELECTRODE SUBSTRATE, REFLECTIVE ELEMENT SUBSTRATE, METHOD FOR MANUFACTURING SAME, ETCHING COMPOSITION USED FOR THE METHOD FOR MANUFACTURING THE REFLECTIVE ELECTRODE SUBSTRATE**

(30) Priority: 05.02.2003 JP 2003027999; 26.03.2003 JP 2003084905; 08.05.2003 JP 2003129824
(71) Applicant: IDEMITSU KOSAN COMPANY LIMITED, Tokyo 100-0005 (JP)
(72) Inventor: INOUE, Kazuyoshi; c/o Central Research Laboratori, Sodegaura-shi, Chiba 299-0205 (JP)
(74) Representative: Gille Hrabal Struck Neidlein Prop Roos
(86) International application number: PCT/JP2003/014810
(87) International publication number: WO 2004/070812

(57) **Abstract**

An etchant for selective etching is used to simplify the production process of a semi-transparent semi-reflective electrode substrate, and temporal loss is not produced by avoiding troublesome repeated works, thereby efficiently providing a semi-transparent semi-reflective electrode substrate. A method for manufacturing a semi-transparent semi-reflective electrode substrate where a metal oxide layer (12) made of at least indium oxide and an inorganic compound layer (14) at least made of Al or Ag are formed in order of mention. The method comprises a step of etching the inorganic compound layer (14) with an etchant A composed of phosphoric acid, nitric acid, and acetic acid and a step of etching the metal oxide layer (12) with an etchant σ containing oxalic acid,

## Description

### TECHNICAL FIELD

The present invention relates to a method for manufacturing a semi-transparent semi-reflective liquid crystal electrode substrate, and an etchant for use in manufacturing a semi-transparent semi-reflective electrode substrate. Further, the present invention relates to a reflective electrode substrate to be used for reflective liquid crystal devices or light-emitting devices, a method for manufacturing the same, and an etchant to be used for the manufacturing method.

### BACKGROUND ART

### Related Art 1 (Semi-transparent Semi-reflective Liquid Crystal Device)

Heretofore, semi-transparent semi-reflective liquid crystal devices have been intensively investigated for the reasons described below.
(1) Semi-transparent semi-reflective liquid crystal devices can provide bright displays both in- and outdoors.
(2) In a case where semi-transparent semi-reflective liquid crystal devices are used in bright light, they operate as reflective liquid crystal devices to reduce power consumption.
(3) Semi-transparent semi-reflective liquid crystal devices are suitable for portable displays because they consume low amounts of power.
(4) Semi-transparent semi-reflective liquid crystal devices can easily provide full color displays.

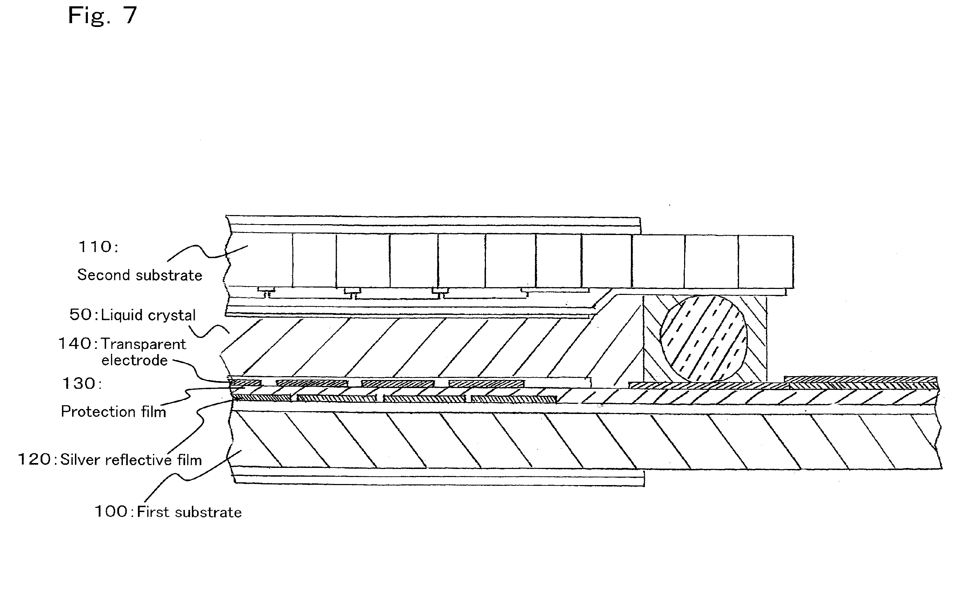

However, in the case of such a semi-transparent semi-reflective liquidcrystal device, it is necessary toprovide a reflective electrode and a transparent electrode as electrodes for driving liquid crystal in one pixel, thus resulting in a complicated manufacturing process, a low yield, and an increase in price. In addition, there is also a problem that it is hard for users to see displays due to the difference in vision between the transparent mode and the reflective mode. From the viewpoint of the problem, Japanese Patent Laid-open No. 2002-49034 or 2002-49033 has disclosed a semi-transparent semi-reflective liquid crystal display device in which silver reflective films 120 are covered with a protection film 130, and transparent electrodes for driving liquid crystal are provided on the protection film 130. Further, the silver reflective films constituting a silver reflective layer and the transparent electrodes for driving liquid crystal are arranged in a staggered format. Fig. 7 is a cross-sectional view which shows the entire structure of the semi-transparent semi-reflective liquid crystal display device disclosed in Japanese Patent Laid-open No. 2002-49034 or 2002-49033. In this liquid crystal display device, a first substrate 100 and a second substrate 110 are provided so as to be opposed to each other, and a space between the first substrate 100 and the second substrate 110 is filled with liquid crystal. As described above, the liquid crystal display device further includes the silver reflective films 120 provided on the first substrate 100, the protection film 130 provided on the silver reflective film 120, the transparent electrodes 140 provided on the protection film 130, and an orientational film provided on the transparent electrodes 140. According to such a structure, it is possible to suppress the growth of crystalline particles constituting the silver reflective film 120 even when the orientational film is subjected to high-temperature treatment after the reflective film is formed, thereby preventing a decrease in reflectivity.

Further, Japanese Patent Laid-open No. 2001-305529 has disclosed a liquid crystal display device using a single semi-transparent reflective film. In this liquid crystal display device, an Si thin film having an auxiliary reflection function is provided below a silver reflection film 120. According to such a structure, the liquid crystal display device can provide displays in a preferred color tone while keeping optimum brightness and contrast in both the transparent mode and reflective mode.

### Related Art 2 (Reflective Liquid Crystal Device)

Heretofore, reflective liquid crystal displays have been actively developed for the reasons described below.
(1) Reflective liquid crystal devices are lightweight and can provide bright displays.
(2) Reflective liquid crystal devices need no backlight so that it is possible to save power consumption.
(3) Reflective liquid crystal devices need little electricity to work and are therefore suitable for portable displays.

Particularly, top emission organic electroluminescence (hereinafter, electroluminescence is simply referred to as "EL") devices are receiving attention for the reasons describedbelow.
(1) EL devices are solid devices and are therefore easy to handle.
(2) EL devices are self-emission devices and therefore do not need any other light-emitting elements.
(3) EL devices are excellent in visibility and are therefore suitable for displays.
(4) EL devices can easily provide full-color displays.

In such a reflective liquid crystal display device, especially in a top emission organic EL display device, a reflective electrode is usually used for an electrode layer for driving. Such a reflective electrode preferably has high reflectivity from the viewpoint of luminous efficiency of the organic EL device.

As a reflective electrode for organic EL devices, a reflective electrode disclosed in WO 00/065879 can be mentioned by way of example. The reflective electrode is formed from Mo, Ru, V, or oxides thereof, and is in contact with an organic material constituting an organic light-emitting device (OLED).

Further, Japanese Patent Laid-open No. 2002-216976 has disclosed an electrode for light-emitting devices. The electrode has a structure in which a Cr film and a Cr oxide film are laminated or a structure in which a film formed from a metal such as Mo, W, Ta, Nb, Ni, or Pt and a film formed from a metal oxide thereof are laminated.

On the other hand, it has been known that a reflective electrode for driving liquid crystal can be formed from, for example, Al having high reflectivity.

### Related Art 3 (Reflective Liquid Crystal Device)

As described in RelatedArt 2, in reflective liquid crystal display devices, especially in top emission organic EL display devices, a reflective electrode is usually used for an electrode layer for driving.

Japanese Patent Laid-open No. 2003-36037 has reported that by making the ratio of the thickness of a metal oxide layer formed from Cr, Ta, W, Ti, Mo, or the like to that of an Ag alloy layer smaller than the ratio of the etching rate of the metal oxide layer to that of the Ag alloy layer, it is possible to reduce the height of a step which may be produced due to etching at the boundary between the metal oxide layer and the Ag alloy layer.

On the other hand, it has been known that a reflective electrode for driving liquid crystal can be formed from, for example, Ag having high reflectivity.

### DISCLOSURE OF THE INVENTION

### First Object (in relation to Related Art 1)

According to Japanese Patent Laid-open Nos. 2002-49034 and 2002-49033, a transparent electrode and a reflective electrode are provided in different layers. Therefore, it is necessary to repeat the cycle including film formation and etching by means of photolithography to form these layers, which makes the manufacturing processes complicated and needs time for transport between different processes.

In order to solve such a problem, the present inventors have intensively investigated, and as a result they have found that it is possible to simplify the process of film formation-etching by using a transparent conductive film which can be etched with an acid not corrosive to metal but has resistance to an etchant for metal.

That is, by using an etchant which enables selective etching, it is possible to avoid a repetition of complicated operations to simplify the manufacturing processes. It is therefore a first object of the present invention to provide a semi-transparent semi-reflective electrode substrate efficiently without time loss.

### Second Object (in relation to Related Art 2)

The above-described reflective electrode formed from Mo, W, Ta, Nb, Ni, Pt, Ru, V, or Cr has low reflectivity, and therefore the luminous efficiency of the organic EL device is lowered.

Particularly, in the case of organic EL devices, such a reflective electrode is used as anode. Therefore, the reflective electrode preferably has a high work function from the viewpoint of luminous efficiency. The work functions of the metals mentioned above such as Mo are relatively high, but are not sufficiently high because the ionization potential of an organic compound used is 5.6 to 5.8 eV.

In a case where Al having high reflectivity is used for a reflective electrode, Al has a work function of 4.2, but it is not so high relative to the ionization potential of an organic compound used.

From the viewpoint of the problem described above, it is a second object of the present invention to provide a reflective electrode substrate having the following properties: (1) low surface resistivity, (2) excellent reflection characteristic and durability, and (3) high work function, and a method for manufacturing such a reflective electrode substrate. The reflective electrode substrate according to the present invention is particularly useful as an electrode substrate for top emission organic EL devices.

### Third Object (in relation to Related Art 3)

As described with reference to the second object, the work functions of the metals mentioned above such as Mo are relatively high, but are not sufficiently high because the ionization potential of an organic compound used is 5.6 to 5.8 eV.

In a case where Ag having high reflectivity is used for a reflective electrode, Ag has a work function of 4.2, but it is not so high relative to the ionization potential of an organic compound used.

From the viewpoint of the problem described above, it is a third object of the present invention to provide a reflective electrode substrate having the following properties: (1) low surface resistivity, (2) excellent reflection characteristic and durability, and (3) high work function, and a method for manufacturing such a reflective electrode substrate. The reflective electrode substrate according to the present invention is particularly useful as an electrode substrate for top emission organic EL devices.

In order to achieve the above objects, the present invention takes the following measures.

### First Invention

First, a first invention for mainly achieving the first object will be described. It is to be noted that the first invention will be described later in more detail with reference to a first embodiment.
1. According to the present invention, there is provided a method for manufacturing a semi-transparent semi-reflective electrode substrate in which a metal oxide layer composed of at least indium oxide and an inorganic compound layer composed of at least Al or Ag are stacked in order of mention, including the steps of:
   subjecting the inorganic compound layer to etching with an etchant λ containing phosphoric acid, nitric acid, and acetic acid; and
   subjecting the metal oxide layer to etching with an etchant σ containing oxalic acid.

   According to a conventional method, it is necessary to repeat the cycle including film formation and etching by means of photolithography to form these layers. However, according to the present invention, it is possible to provide these layers by first forming films and then subjecting each of the films to etching, thereby simplifying the manufacturing processes and reducing the time required for manufacturing the semi-transparent semi-reflective electrode substrate as compared to the conventional method.
   The etchant σ containing oxalic acid may contain other acids such as hydrochloric acid, nitric acid, sulfonic acid, and disulfonic acid in small amounts as long as the etchant σ do not cause damage to the inorganic compound layer composed of Ag or Al.
2. In the present invention, it is preferred that when the etching rate of the metal oxide layer with the etchant λ is defined as A and the etching rate of the inorganic compound layer with the etchant λ is defined as B, the ratio B/A is 10 or more.
   Here, the word "etching rate ratio" is defined as follows: Etching rate ratio = Etching rate of inorganic compound layer composed of Ag or Al / Etching rate of metal oxide layer
   If the etching rate ratio is less than 10, the metal oxide layer provided below the inorganic compound layer is also etched when the inorganic compound layer composed of Ag or Al is subjected to etching, thereby causing damage to the metal oxide layer.
   In general, etching is carried out for a time period about 1.2 to 2.0 times longer than just etching time. Here, the time period from the initiation of etching to the end of etching is defined as "just etching time", and the time period when etching is further carried out over the just etching time is defined as "over-etching time". In consideration of the over-etching time, the metal oxide layer provided below the inorganic compound layer is subjected to etching for a time period about 0.2 to 1.0 times the just etching time. Therefore, it is necessary to make the ratio of the etching rate of the inorganic compound layer composed of Ag or Al to the etching rate of the metal oxide layer large.
3. In the present invention, it is also preferred that the etchant λ contains 30 to 60 wt% of phosphate ions, 1 to 5 wt% of nitrate ions, and 30 to 50 wt% of acetate ions.
   If the etchant λ is not a mixed acid having such negative ion composition, it is difficult to set the etching rate ratio to 10 or more, thus resulting in a case where the metal oxide layer provided below the inorganic compound layer is damaged. Further, if the etchant λ does not have such negative ion composition described above, there is also a case where the etching rate is decreased, thereby significantly increasing the time for etching. Furthermore, if the etchant λ does not have such negative ion composition described above, there is also a case where the etching rate is increased so that it becomes impossible to control the etching rate, thereby causing damage to the metal oxide layer provided below the inorganic compound layer.
4. In the present invention, it is also preferred that the metal oxide layer contains a lanthanoid group metal oxide.
   If the metal oxide layer composed of at least indium oxide does not contain a lanthanoid group metal oxide, there is a case where the etching rate ratio becomes less than 10. Further, if the metal oxide layer composed of at least indium oxide does not contain a lanthanoid group metal oxide, it becomes difficult to etch the metal oxide layer with an acid mainly containing oxalic acid.
   On the other hand, by adding a lanthanoid group metal oxide to the metal oxide layer, it is possible to set the etching rate ratio to 10 or more in most cases. Further, by adding a lanthanoid group metal oxide to the metal oxide layer, it is possible to etch the metal oxide layer with an acid mainly containing oxalic acid.
5. In the present invention, it is also preferred that the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbiumoxide, thuliumoxide, ytterbiumoxide, and lutetium oxide.
   Preferred examples of a lanthanoid group metal oxide include cerium oxide, praseodymium oxide, neodymium oxide, samarium oxide, and terbium oxide, because these metal oxides are atoxic and easily available. Further, these oxides are preferable from the viewpoint of price, ease of increase in sintered density due to sintering, sintering time, and sintering temperature.
6. In the present invention, it is also preferred that the ratio of the lanthanoid group metal oxide contained in the metal oxide layer is 0.1 atomic % or more but less than 10 atomic % with respect to the total metal atoms of the metal oxides contained in the metal oxide layer.
   The ratio of the lanthanoid group metal oxide contained in the metal oxide layer is 0.1 to 20 atomic %, preferably 1 to 8 atomic %, more preferably 2 to 7 atomic %, with respect to the total metal atoms of the metal oxides contained in the metal oxide layer.
   If the ratio of the lanthanoid group metal oxide contained in the metal oxide layer is less than 0.1 atomic % with respect to the total metal atoms of the metal oxides contained in the metal oxide layer, there is a case where the effect obtained by adding a lanthanoid group metal oxide cannot be exhibited, that is, it is impossible to set the etching rate ratio to 10 or more. On the other hand, if the ratio of the lanthanoid group metal oxide contained in the metal oxide layer is 10 atomic % or more with respect to the total metal atoms of the metal oxides contained in the metal oxide layer, there is a case where the conductivity of the metal oxide layer becomes poor and the transparency of the metal oxide layer is lowered.
7. In the present invention, it is also preferred that the inorganic compound layer contains 0.1 to 3 wt% of at least one metal selected from among Au, Pt, and Nd.
   The present invention can be carried out by using only Ag for the inorganic compound layer. However, by adding Au, Pt, or Nd to the inorganic compound layer, it is possible to decrease resistance, to bring the inorganic compound layer into contact with a layer provided below the inorganic compound layer more firmly, and to make the inorganic compound layer more stable toward heat and moisture. The amount of Au, Pt, or Nd to be added to the inorganic compound layer is preferably 0.1 to 3 wt%. In the present invention, it is to be noted that even in a case where a metal layer provided on the metal oxide layer is composed of Ag or Al only, the metal layer is referred to as an inorganic compound layer for the sake of convenience. Further, in the present invention, a compound obtained by adding Au, Pt, or Nd, to Ag or Al is also referred to as an inorganic compound for the sake of convenience.
   If the amount of Au, Pt, or Nd to be added to the inorganic compound layer is less than 0.1 wt%, it is difficult to obtain the effects described above, that is, it is difficult to further decrease resistance, to bring the inorganic compound layer into contact with the metal oxide layer provided below the inorganic compound layer more firmly, and to make the inorganic compound layer more stable toward heat and moisture. On the other hand, if the amount of Au, Pt, or Nd to be added to the inorganic compound layer exceeds 3 wt% , there is a case where resistance is increased, the contact between the inorganic compound layer and a layer provided below the inorganic compound layer becomes poor, the inorganic compound layer becomes unstable toward heat and moisture, or the resultant product becomes expensive. The amount of Au, Pt, or Nd to be added to the inorganic compound layer is preferably 0.2 to 2 wt%, more preferably 0.3 to 1.5 wt%.
   The following means 8 to 14 for achieving the first object have the same operational advantages as the above-describedmeans 1 to 7 except that the means 8 to 14 include the step of forming a second metal oxide layer on the inorganic compound layer composed of Al or Ag.
8. According to the present invention, there is also provided a method for manufacturing a semi-transparent semi-reflective electrode substrate in which a first metal oxide layer composed of at least indium oxide, an inorganic compound layer composed of at least Al or Ag, and a second metal oxide layer composed of at least indium oxide or zinc oxide are stacked in order of mention, the method including the steps of:
   subjecting the second metal oxide layer and the inorganic compound layer to etching with an etchant λ containing phosphoric acid, nitric acid, and acetic acid; and
   subjecting the first metal oxide layer to etching with an etchant σ containing oxalic acid.
9. In the present invention, it is preferred that when the etching rate of the first metal oxide layer with the etchant λ is defined as A and the etching rate of the inorganic compound layer with the etchant λ is defined as B, the ratio B/A is 10 or more, and wherein when the etching rate of the inorganic compound layer with the etchant λ is defined as C and the etching rate of the second metal oxide layer with the etchant λ is defined as D, the ratio C/D is in the range of 0.5 to 2.0.
10. In the present invention, it is also preferred that the etchant λ contains 30 to 60 wt% of phosphate ions, 1 to 5 wt% of nitrate ions, and 30 to 50 wt% of acetate ions.
11. In the present invention, it is also preferred that the first metal oxide layer contains a lanthanoid group metal oxide.
12. In the present invention, it is also preferred that the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbiumoxide, thuliumoxide, ytterbiumoxide, and lutetium oxide.
13. In the present invention, it is also preferred that the ratio of the lanthanoid group metal oxide contained in the metal oxide layer is 0.1 atomic % or more but less than 10 atomic % with respect to the total metal atoms of the metal oxides contained in the metal oxide layer.
14. In the present invention, it is also preferred that the inorganic compound layer contains 0.1 to 3 wt% of at least one metal selected from among Au, Pt, and Nd.

### Second Invention

Next, a second invention for mainly achieving the second object will be described. It is to be noted that the second invention will be described later in more detail with reference to a second embodiment.

In order to achieve the second object, the present inventors have intensively investigated, and as a result they have found that by using an inorganic compound layer composed of Al or the like having a high reflectivity as an electrode layer and using a metal oxide layer containing a specific element as a charge injection layer, it is possible to obtain a reflective electrode substrate having a low specific resistance and a high work function.

The second invention is divided into the following three groups (i.e., groups 2-1, 2-2, and 2-3).
1. According to the group 2-1 of the second invention, there is provided a reflective electrode substrate in which an inorganic compound layer composed of at least Al and a metal oxide layer composed of at least indium oxide or composed of indium oxide and one of or both of zinc oxide and tin oxide are stacked in order of mention on a substrate.
   According to the group 2-2 of the second invention, there is provided a method for manufacturing such a reflective electrode substrate described above, including the step of subjecting the metal oxide layer and the inorganic compound layer to batch etching with an etchant containing phosphoric acid, nitric acid, and acetic acid.
   According to the group 2-3 of the second invention, there is provided an etching composition for an etchant, composed of phosphoric acid, nitric acid, and acetic acid.
2. If the metal oxide layer of the reflective electrode substrate according to the group 2-1 of the second invention has a crystalline structure, the surface of the metal oxide layer becomes rough. In addition, there is a case where a leakage current occurs due to the irregularities of the surface. If such a reflective electrode substrate is used for an organic EL device, there is a case where the luminous efficiency of the organic EL device is lowered. Therefore, it is necessary for the metal oxide layer to be amorphous.
   The amount of indium oxide contained in the metal oxide layer is preferably 60 or more atomic % but less than 100 atomic % with respect to the total metal atoms of the metal oxides contained in the metal oxide layer. If the amount of indium oxide contained in the metal oxide layer is less than 60 atomic % with respect to the total metal atoms of the metal oxides contained in the metal oxide layer, the specific resistance of the metal oxide layer is increased. On the other hand, if the amount of indium oxide contained in the metal oxide layer is 100 atomic % with respect to the total metal atoms of the metal oxides contained in the metal oxide layer, there is a case where the metal oxide layer has a crystalline structure so that a leakage current occurs. In order to prevent the crystallization of the metal oxide layer, water or hydrogen may be added to the metal oxide layer.
   Further, the amount of indium oxide contained in the metal oxide layer is preferably 96 atomic % or less, more preferably 95 atomic % or less, with respect to the total metal atoms of the metal oxides contained in the metal oxide layer. By setting the amount of indium oxide contained in the metal oxide layer to 96 atomic % or less with respect to the total metal atoms of the metal oxides contained in the metal oxide layer, it is possible to make the metal oxide layer amorphous without adding water or hydrogen to the metal oxide layer. Alternatively, zinc oxide may be added to the metal oxide layer to make the metal oxide layer amorphous. In this case, the atomic ratio represented by [In] / ([In]+[Zn]) is in the range of 0.7 to 0. 95, preferably in the range of 0.85 to 0.95, more preferably in the range of 0.8 to 0.9. Here, [In] and [Zn] represent the number of indium atoms and the number of zinc atoms in the metal oxide layer, respectively. It is to be noted that the word "number of atoms" means the number of atoms per unit volume in the composition of the metal oxide layer.
   The thickness of the metal oxide layer is in the range of 2 to 300 nm, preferably in the range of 30 to 200 nm, more preferably in the range of 10 to 120 nm. If the thickness of the metal oxide layer is less than 2 nm, it is impossible to sufficiently protect the inorganic compound layer. On the other hand, if the thickness of the metal oxide layer exceeds 300 nm, the reflectivity of the reflective electrode substrate is lowered.
   The thickness of the inorganic compound layer is in the range of 10 to 300 nm, preferably in the range of 30 to 250 nm, more preferably in the range of 50 to 200 nm. If the thickness of the inorganic compound layer is less than 10 nm, there is a case where light emitted from a light-emitting layer cannot be sufficiently reflected. In addition, there is also a case where the resistance of the reflective electrode becomes too high. On the other hand, if the thickness of the inorganic compound layer exceeds 300 nm, there is a case where a step is produced in the inorganic compound layer due to batch etching of the metal oxide layer and the inorganic compound layer with an etchant. The surface of the inorganic compound layer may be a diffuse reflector.
   A material for forming a substrate on which the inorganic compound layer etc. are to be provided is not particularly limited. Examples of a material for forming a substrate include glass, plastics, and silicon.
   The inorganic compound layer contains Al as a main ingredient, and preferably contains 0.1 to 3 wt% of at least one metal selected from among Au, Pt, and Nd in addition to Al.
   The amount of at least one metal selected from among Au, Pt, and Nd to be added to the inorganic compound layer is 0.1 to 3 wt%, preferably 0.1 to 2 wt%, more preferably 0.5 to 2 wt%. If the amount of at least one metal selected from among Au, Pt, and Nd to be added to the inorganic compound layer is less than 0.1 wt%, the effect obtained by adding such a metal is not sufficiently exhibited. On the other hand, if the amount of at least one metal selected from among Au, Pt, and Nd to be added to the inorganic compound layer exceeds 3 wt%, the conductivity of the inorganic compound layer is lowered.
   A metal other than the above-mentioned metals such as Au may be added as a third ingredient to the inorganic compound layer as long as the third ingredient does not affect the stability and resistance of the inorganic compound layer. The word "third ingredient" means a metal ingredient other than the main ingredient Al and the above-mentioned metals such as Au.
   The work function of the metal oxide layer is 5.6 eV or more. In a case where the reflective electrode substrate having a metal oxide layer with a work function of 5.6 eV or more is used for an organic EL device, it is possible to increase the luminous efficiency of the organic EL device. For this reason, the work function of the metal oxide layer is preferably 5.6 eV or more, more preferably 5.8 eV or more.
   By adding a lanthanoid group metal oxide to the metal oxide layer, it is easy for the metal oxide layer to have a work function of 5.6 eV or more.
   The lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.
   The ratio of the lanthanoid group metal oxide contained in the metal oxide layer is 0.1 to 10 atomic % with respect to the total metal atoms of the metal oxides contained in the metal oxide layer.
   The ratio of the lanthanoid group metal oxide contained in the metal oxide layer is 0.1 atomic % or more but less than 10 atomic % , preferably 1 atomic % ormore but less than 10 atomic % , more preferably 2 atomic % or more but less than 5 atomic %, with respect to the total metal atoms of the metal oxides contained in the metal oxide layer. If the ratio of the lanthanoid group metal oxide contained in the metal oxide layer is less than 0.1 atomic % with respect to the total metal atoms of the metal oxides contained in the metal oxide layer, there is a case where the metal oxide layer cannot have a work function of 5.6 eV or more. On the other hand, if the ratio of the lanthanoid group metal oxide contained in the metal oxide layer is 10 atomic % or more with respect to the total metal atoms of the metal oxides contained in the metal oxide layer, there is a case where the specific resistance of the metal oxide layer becomes too high so that the conductivity thereof is lowered.
3. The reflective electrode substrate according to the group 2-1 of the second invention can be manufactured by a method according the group 2-2 of the second invention.
   The metal oxide layer is preferably formed in an atmosphere having an oxygen partial pressure of 0 to 5 %. If the oxygen partial pressure exceeds 5 %, there is a case where the specific resistance of the metal oxide layer becomes too high. The oxygen partial pressure is more preferably 0 to 2 %, particularly preferably 0 to 1 %.
   The manufacturing method of a reflective electrode substrate according to the group 2-2 of the second invention includes the step of subjecting the metal oxide layer and the inorganic compound layer to batch etching with an etchant containing phosphoric acid, nitric acid, and acetic acid.
   When the etching rate of the inorganic compound layer with the etchant described above is defined as A, and the etching rate of the metal oxide layer with the etchant described above is defined as B, the ratio B/A is set to 0.5 to 2.0.
   The ratio of the etching rate B to the etching rate A, that is, the ratio B/A is in the range of 0.5 to 2.0, preferably in the range of 0.6 to 1.5, more preferably in the range of 0. 6 to 1.2. If the etching rate ratio B/A is less than 0.5, the etching rate B becomes too fast relative to the etching rate A so that there is a case where the inorganic compound layer is more widely etched than the metal oxide layer, and as a result a step is produced at the boundary between the metal oxide layer and the inorganic compound layer. On the other hand, if the etching rate ratio B/A exceeds 2.0, the etching rate B is too slow relative to the etching rate A so that there is a case where the metal oxide layer is more widely etched than the inorganic compound layer, and as a result, a step is produced at the boundary between the metal oxide layer and the inorganic compound layer.
   The etchant is composed of 30 to 60 wt% of phosphoric acid, 1 to 5 wt% of nitric acid, and 30 to 50 wt% of acetic acid. If the concentration of phosphoric acid in the etchant is less than 30 wt%, or the concentration of nitric acid in the etchant is less than 1 wt%, or the concentration of acetic acid in the etchant is less than 30 wt%, there is a case where the life span of the etchant is shortened. In addition, there is also a case where the inorganic compound layer is not sufficiently etched so that residues are left, or it becomes impossible to subject the metal oxide layer and the inorganic compound layer to batch etching.
   On the other hand, if the concentration of phosphoric acid in the etchant exceeds 65 wt%, or the concentration of nitric acid in the etchant exceeds 5 wt%, or the concentration of acetic acid in the etchant exceeds 50 wt%, the etching rate A and the etching rate B become too fast so that there is a case where the etching rates cannot be controlled and therefore the etching rate ratio B/A cannot be set to a value within the above range (i.e., 0.5 to 2.0). In addition, there is also a case where the metal oxide layer is deteriorated.
   The etchant is more preferably composed of 30 to 50 wt % of phosphoric acid, 1 to 5 wt% of nitric acid, and 30 to 50 wt% of acetic acid.
   By adding a lanthanoid group metal oxide to the metal oxide layer, it becomes easy to control the etching rate of the metal oxide layer, thereby enabling the etching rate ratio B/A to be set to 0.5 to 2.0 easily.
   The metal oxide layer is preferably amorphous. When the metal oxide layer is amorphous, substantially no residue is left on the end face obtained by etching (that is, on the etched surface) . In addition, the obtained reflective electrode has a tapered shape, and therefore a short circuit hardly occurs between the reflective electrode and an electrode to be provided opposite to the reflective electrode.
4. The group 2-3 according to the second invention is directed to an etchant to be used for etching in the manufacturing method of a reflective electrode substrate according to the group 2-2 of the second invention, including an etching composition containing 30 to 60 wt% of phosphoric acid, 1 to 5 wt% of nitric acid, and 30 to 50 wt% of acetic acid. Here, the word "etching composition" means a composition contained in an etchant.

### Third Invention

Next, a third invention for mainly achieving the third object will be described. It is to be noted that the third invention will be described later in more detail with reference to a third embodiment.

The third invention is divided into the following two groups (i.e., groups 3-1 and 3-2).

In order to achieve the third object, the present inventors have intensively investigated, and as a result they have found that by using an electrode layer obtained by stacking an inorganic compound layer composed of Ag or the like having a high reflectivity and a metal oxide layer containing a specific element, it is possible to obtain a reflective electrode substrate having a low specific resistance and a high work function.

### 1. Group 3-1 (Reflective Electrode Substrate)

According to the group 3-1 of the third invention, there is provided a reflective electrode substrate in which an inorganic compound layer composed of at least Ag and a metal oxide layer composed of at least indium oxide and a lanthanoid group metal oxide are stacked on a substrate in order of mention. According to the group 3-2 of the third invention, there is provided a method for manufacturing the reflective electrode substrate according to the group 3-1, including the steps of subjecting the metal oxide layer to etching with an etchant containing oxalic acid, and subjecting the inorganic compound layer to etching with an etchant containing phosphoric acid, nitric acid, and acetic acid.

If the metal oxide layer of the reflective electrode substrate according to the group 3-1 of the third invention has a crystalline structure, the surface of the metal oxide layer becomes rough. In addition, there is also a case where a leakage current occurs due to the irregularities of the surface. If such a reflective electrode substrate is used for an organic EL device, there is a case where the luminous efficiency of the organic EL device is lowered. Therefore, it is necessary for the metal oxide layer to be amorphous.

The amount of indium atoms contained in the metal oxide layer is preferably 60 atomic % or more with respect to the total metal atoms contained in the metal oxide layer. If the amount of indium atoms contained in the metal oxide layer is less than 60 atomic % with respect to the total metal atoms contained in the metal oxide layer, the specific resistance of the metal oxide layer is increased. In order to prevent the occurrence of a leakage current due to the crystallization of the metal oxide layer, water or hydrogen may be added to the metal oxide layer when the metal oxide layer is formed. Further, the amount of indium atoms contained in the metal oxide layer is preferably 96 atomic % or less, more preferably 95 atomic % or less, with respect to the total metal atoms contained in the metal oxide layer. By setting the amount of indium atoms contained in the metal oxide layer to 96 atomic % or less with respect to the total metal atoms contained in the metal oxide layer, it is possible to make the metal oxide layer amorphous without adding water or hydrogen to the metal oxide layer when the metal oxide layer is formed, thereby preventing the occurrence of a leakage current. Alternatively, zinc oxide may be added to the metal oxide layer to make the metal oxide layer amorphous. In this case, the atomic ratio represented by [In]/([In]+[Zn]) is in the range of 0.7 to 0.95, preferably in the range of 0.85 to 0.95, more preferably in the range of 0.8 to 0.9. Here, [In] and [Zn] represent the number of indium atoms and the number of zinc atoms in the metal oxide layer, respectively. Alternatively, tin oxide may be added to the metal oxide layer instead of zinc oxide or tin oxide may be added to the metal oxide layer together with zinc oxide. In this case, the atomic ratio represented by [In]/([In]+[Sn]) is in the range of 0.7 to 0.97, preferably in the range of 0.85 to 0.95, more preferably in the range of 0.85 to 0.95. Here, [Sn] represents the number of tin atoms in the metal oxide layer. It is to be noted that the word "number of atoms" means the number of atoms per unit volume in the composition of the metal oxide layer.

The work function of the metal oxide layer is preferably 5.25 eV or more, more preferably 5.60 eV or more, even more preferably 5.80 eV or more.

The lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.

The ratio of the lanthanoid group metal atoms contained in the metal oxide layer is 0.1 to 20 atomic % with respect to the total metal atoms of the metal oxides contained in the metal oxide layer.

The ratio of the lanthanoid group metal atoms contained in the metal oxide layer is preferably 1 or more atomic % but less than 10 atomic %, more preferably 2 or more atomic % but less than 5 atomic %, with respect to the total metal atoms of the metal oxides contained in the metal oxide layer. If the ratio of the lanthanoid group metal atoms contained in the metal oxide layer is less than 0.1 atomic % with respect to the total metal atoms of the metal oxides contained in the metal oxide layer, there is a case where the metal oxide layer cannot have a work function of 5.25 eV or more. On the other hand, if the ratio of the lanthanoid group metal atoms contained in the metal oxide layer is 20 atomic % or more with respect to the total metal atoms of the metal oxides contained in the metal oxide layer, there is a case where the specific resistance of the metal oxide layer becomes too high so that the conductivity of the metal oxide layer is lowered.

The thickness of the metal oxide layer is in the range of 2 to 300 nm, preferably in the range of 30 to 200 nm, more preferably in the range of 10 to 120 nm. If the thickness of the metal oxide layer is less than 2 nm, it is impossible to sufficiently protect the inorganic compound layer. On the other hand, if the thickness of the metal oxide layer exceeds 300 nm, the reflectivity of the reflective electrode substrate is lowered.

The thickness of the inorganic compound layer is in the range of 10 to 300 nm, preferably in the range of 30 to 250 nm, more preferably in the range of 50 to 200 nm. If the thickness of the inorganic compound layer is less than 10 nm, there is a case where light emitted from a light-emitting layer is not sufficiently reflected. In addition, there is also a case where the resistance of the reflective electrode becomes too high. On the other hand, if the thickness of the inorganic compound layer exceeds 300 nm, there is a case where a step is produced in the inorganic compound layer due to etching of the inorganic compound layer with an etchant. The surface of the inorganic compound layer may be a diffusion reflector.

A material for forming a substrate on which the inorganic compound layer etc. are to be provided is not particularly limited. Examples of a material for forming a substrate include glass, plastics, and silicon.

The inorganic compound layer preferably contains 0.1 to 3 wt% of at least one metal selected from among Au, Cu, Pd, Zr, Ni, Co, and Nd, in addition to Ag that is a main ingredient.

The amount of at least one metal selected from among Au, Cu, Pd, Zr, Ni, Co, and Nd to be added to the inorganic compound layer is 0.1 to 3 wt%, preferably 0.1 to 2 wt%, more preferably 0.5 to 2 wt%. If the amount of at least one metal selected from among Au, Cu, Pd, Zr, Ni, Co, and Nd to be added to the inorganic compound layer is less than 0.1 wt%, the effect obtained by adding such a metal is not sufficiently exhibited. On the other hand, if the amount of at least one metal selected from among Au, Cu, Pd, Zr, Ni, Co, and Nd to be added to the inorganic compound layer exceeds 3 wt%, the conductivity of the inorganic compound layer is lowered.

A metal other than the above-mentioned metals such as Au may be added as a third ingredient to the inorganic compound layer as long as the third ingredient does not affect the stability and resistance of the inorganic compound layer.

### 2. Group 3-2 (Manufacturing Method)

The reflective electrode substrate according to the group 3-1 of the third invention can be formed by the following manufacturing method according to the group 3-2 of the third invention.

The metal oxide layer is preferably formed by sputtering in an atmosphere having an oxygen partial pressure of 0 to 5 %. If the oxygen partial pressure exceeds 5 %, there is a case where the specific resistance of the metal oxide layer becomes too high. The oxygen partial pressure is more preferably 0 to 2 %, particularly preferably 0 to 1 %.

The manufacturing method according to the group 3-2 of the third invention has the steps of subjecting the metal oxide layer to etching with an etchant containing oxalic acid, and subjecting the inorganic compound layer to etching with an etchant containing phosphoric acid, nitric acid, and acetic acid.

The etchant to be used for etching the metal oxide layer preferably contains 1 to 10 wt% of oxalic acid. If the concentration of oxalic acid is less than 1 wt%, there is a case where the etching rate of the metal oxide layer becomes slow. On the other hand, if the concentration of oxalic acid exceeds 10 wt%, there is a case where oxalic acid is crystallized. The concentration of oxalic acid in the etchant is particularly preferably 2 to 5 wt%.

The etchant to be used for etching the inorganic compound layer is composed of 30 to 60 wt% of phosphoric acid, 1 to 5 wt% of nitric acid, and 30 to 50 wt% of acetic acid. If the concentration of phosphoric acid in the etchant to be used for etching the inorganic compound layer is less than 30 wt%, or the concentration of nitric acid in the etchant is less than 1 wt%, or the concentration of acetic acid in the etchant is less than 30 wt%, there is a case where the life span of the etchant is shortened. In addition, there is also a case where the inorganic compound layer is not sufficiently etched so that residues are left, or it is impossible to etch the inorganic compound layer.

The etchant to be used for etching the inorganic compound layer is more preferably composed of 30 to 50 wt % of phosphoric acid, 1 to 5 wt% of nitric acid, and 30 to 50 wt% of acetic acid.

Themetal oxide layer of the reflective electrode substrate of the present invention is amorphous. Therefore, substantially no residue is left on the end face obtained by etching (that is, on the etched surface). In addition, the obtained reflective electrode has a tapered shape, and therefore a short circuit hardly occurs between the reflective electrode and an electrode to be provided opposite to the reflective electrode.

### BRIEF DESCRIPTION OF THE DRAWINGS

Figs. 1 (1) to 1(5) are cross-sectional views which show the manufacturing steps of a semi-transparent semi-reflective electrode substrate according to an example of a first embodiment of the present invention;
Figs. 2(1) to 2(6) are cross-sectional views which show the manufacturing steps of a semi-transparent semi-reflective electrode substrate according to another example of the first embodiment of the present invention;
Fig. 3 is a cross-sectional view of the semi-transparent semi-reflective electrode substrate according to an example of the first embodiment of the present invention;
Fig. 4 is a cross-sectional view of the semi-transparent semi-reflective electrode substrate according to another example of the first embodiment of the present invention;

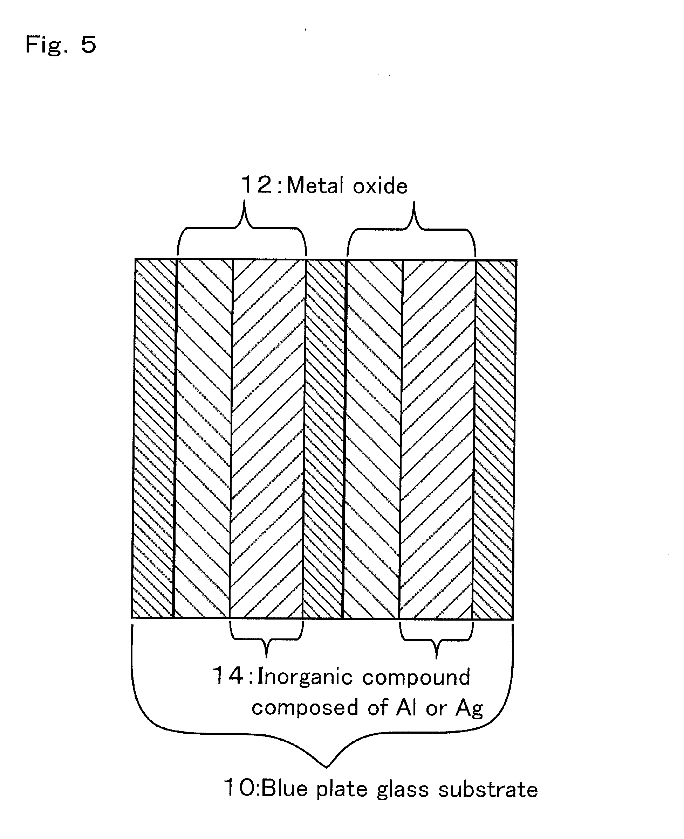

Fig. 5 is a plan view of the semi-transparent semi-reflective electrode substrate according to an example of the first embodiment of the present invention;

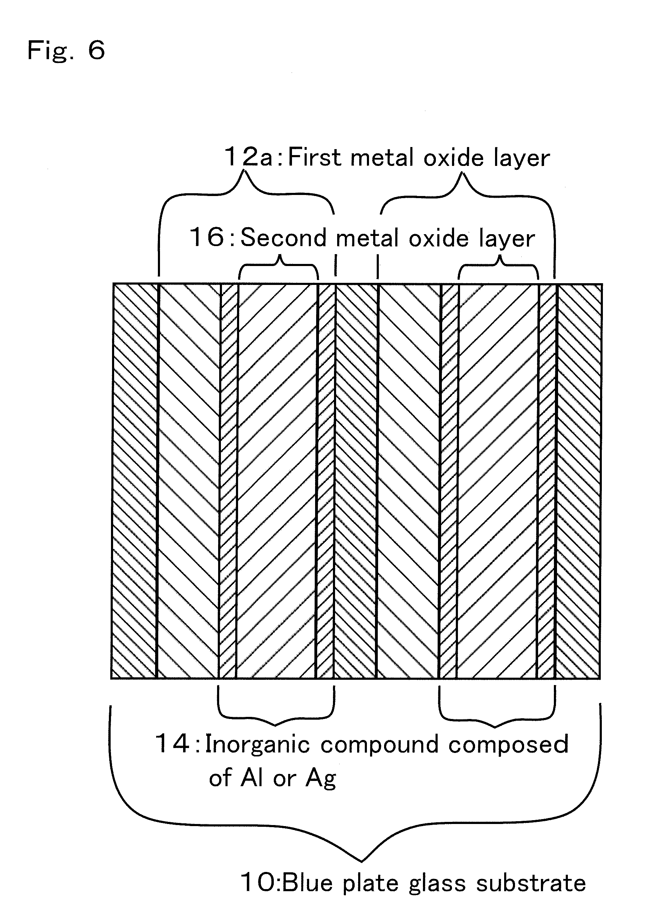

Fig. 6 is a plan view of the semi-transparent semi-reflective electrode substrate according to another example of the first embodiment of the present invention;
Fig. 7 is a cross-sectional view of a conventional semi-transparent semi-reflective electrode substrate;
Figs. 8(1) to (4) are cross-sectional views which show the manufacturing steps of a reflective electrode substrate according to an example of a second embodiment of the present invention;
Fig. 9 is a vertical cross-sectional view of the reflective electrode substrate according to an example of the second embodiment of the present invention;
Figs. 10(1) to (4) are cross-sectional views which show a reflective electrode substrate and the manufacturing method thereof according to an example of a third embodiment of the present invention; and
Fig. 11 is a vertical cross-sectional view of the reflective electrode substrate according to an example of the third embodiment of the present invention.

### BEST MODE FOR CARRYING OUT THE INVENTION

Hereinbelow, preferred embodiments according to the present invention will be described in detail with reference to the accompanying drawings.

### First Embodiment

Hereinbelow, a preferred first embodiment according to the present invention will be described with reference to the accompanying drawings. The first embodiment is an embodiment related to the first invention, and will be described with reference to 11 examples (i.e., Examples 1-1 to 1-11) and 2 comparative examples (i.e., Comparative Examples 1-1 and 1-2).

### (Example 1-1)

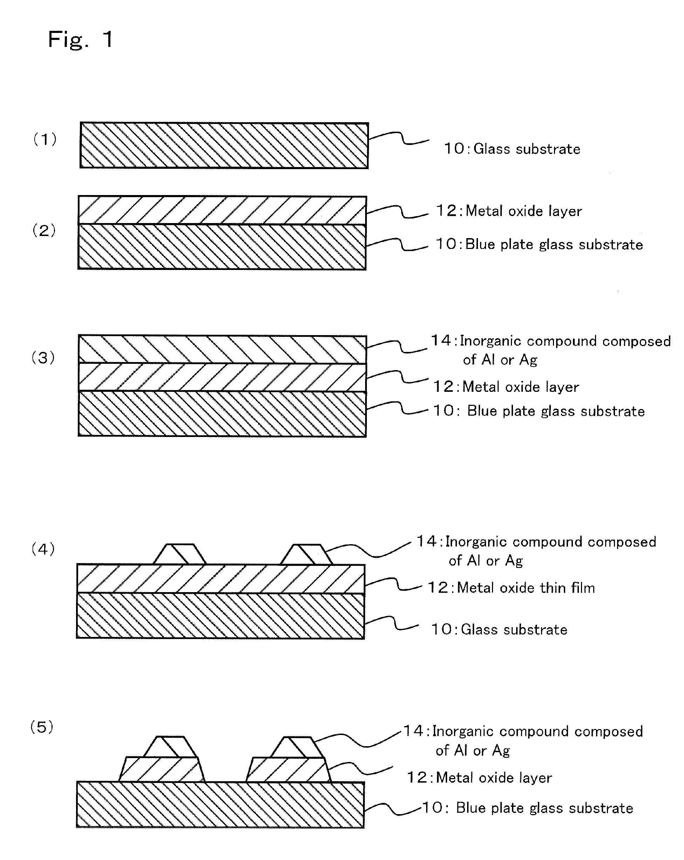

First, a blue plate glass substrate 10 coated with SiO₂ was prepared (see Fig. 1(1)). On such a blue plate glass substrate 10, a metal oxide layer 12 was formed using a first target composed of indium oxide-cerium oxide (Ce/ (In+Ce) = 4.5 atomic %) with a DC magnetron sputtering system (manufactured by Shinko Seiki Co., Ltd.) (see Fig. 1(2)).

In this regard, it is to be noted that the temperature of the blue plate glass substrate 10 at the time when the metal oxide layer 12 was formed was 200°C, the thickness of the metal oxide layer 12 was 75 nm, and the specific resistance of the metal oxide layer 12 was 380 µΩcm.

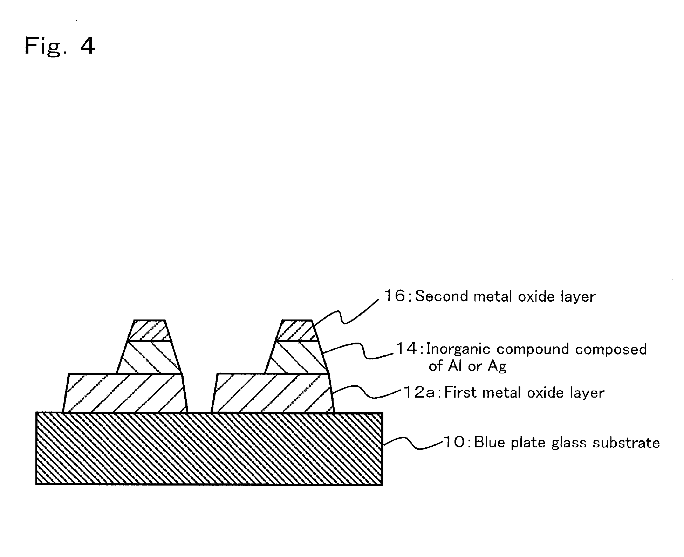

Next, on the metal oxide layer 12, an inorganic compound layer 14 was formed using an Ag target composed of Ag-Pd-Cu (98.5: 0.5: 1.0 wt%) (see Fig. 1(3)). The thickness of the inorganic compound layer 14 was 100 nm. It is to be noted that the metal oxide layer 12 and the inorganic compound layer 14 containing Ag as a main ingredient are collectively called an electrode layer. In Figs. 1 to 4, a layer formed on the metal oxide layer 12 or 12a is referred to as an inorganic compound layer 14 composed of Ag or Al, for the sake of convenience. However, such an inorganic compound layer 14 may be composed of Ag or Al only or a compound containing Ag or Al as a main ingredient. In this regard, it is to be noted that in the present invention, a compound obtained by adding Au, Pt, or Nd to Ag or Al is referred to as an inorganic compound for the sake of convenience.

Next, the inorganic compound layer 14 was subjected to etching. After the completion of etching, residual portions were provided as a plurality of lines of the inorganic compound layer 14 (see Fig. 1(4)).

A mask pattern used for etching was designed such that the width of each of the lines of the inorganic compound layer 14 became 40 µm and the space between the adjacent lines of the inorganic compound layer 14 became 70 µm.

Etching of the inorganic compound layer 14 was carried out in the following manner using the mask pattern described above. First, a resist was applied onto the inorganic compound layer 14. A glass plate having the mask pattern was placed on the resist, and then the resist was exposed to light, developed, and post-baked.

Next, the inorganic compound layer 14 was subjected to etching using an aqueous solution containing 40 wt% of phosphate ions, 2.5 wt% of nitrate ions, and 40 wt% of acetate ions so that the over-etching time became 100% of the just etching time (see Fig. 1(4)). It is to be noted that the aqueous solution is one example of an etchant λ claimed in the present invention.

Next, the blue plate glass substrate 10 which had been subjected to etching was washed with water, and was then dried.

Next, the metal oxide layer 12 was subjected to etching. After the completion of etching, residual portions were provided as a plurality of lines of the metal oxide layer 12 (see Fig. 1(5)).

A mask pattern used for etching of the metal oxide layer 12 was designed such that the width of each of the lines of the metal oxide layer 12 became 90 µm and the space between the adj acent lines of the metal oxide layer 12 became 20 µm.

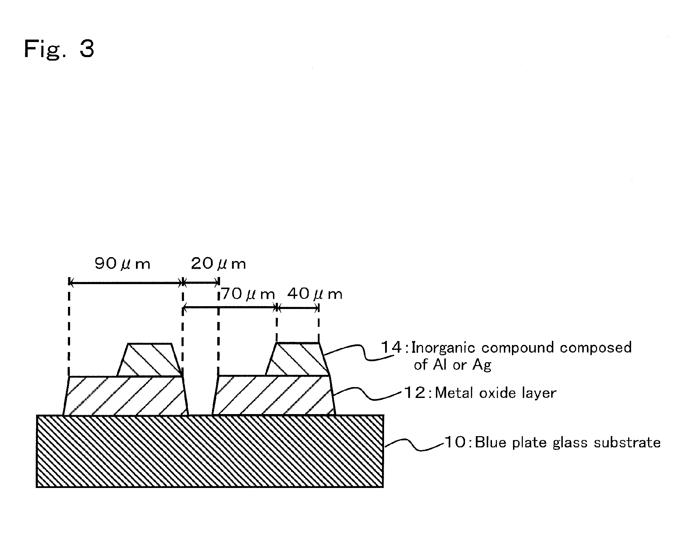

Etching of the metal oxide layer 12 was carried out in the following manner using the mask pattern described above. First, a resist was applied onto the electrode layer. A glass plate having the mask pattern was placed on the resist, and then the resist was exposed to light, developed, and post-baked (see Fig. 1(5)). In this regard, it is to be noted that exposure of the resist was carried out in such a manner that one of the side edges of each line of the inorganic compound layer 14 and one of the side edges of each line of the metal oxide layer 12 were overlapped one another as shown in Fig. 3.

Next, the metal oxide layer 12 was subjected to etching using a 4 wt% aqueous oxalic acid solution. It is to be noted that the aqueous solution is one example of an etchant σ claimed in the present invention. After the resist was removed, the resistance of one of the electrodes having a length of 5 cm was measured and was found to be 0.65 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where the aqueous solution containing 40 wt% of phosphate ions, 2.5 wt% of nitrate ions, and 40 wt% of acetate ions at a temperature of 30°C was used as an etchant, the ratio of the etching rate of the inorganic compound layer 14 to that of the metal oxide layer 12 was 40.

### (Example 1-2)

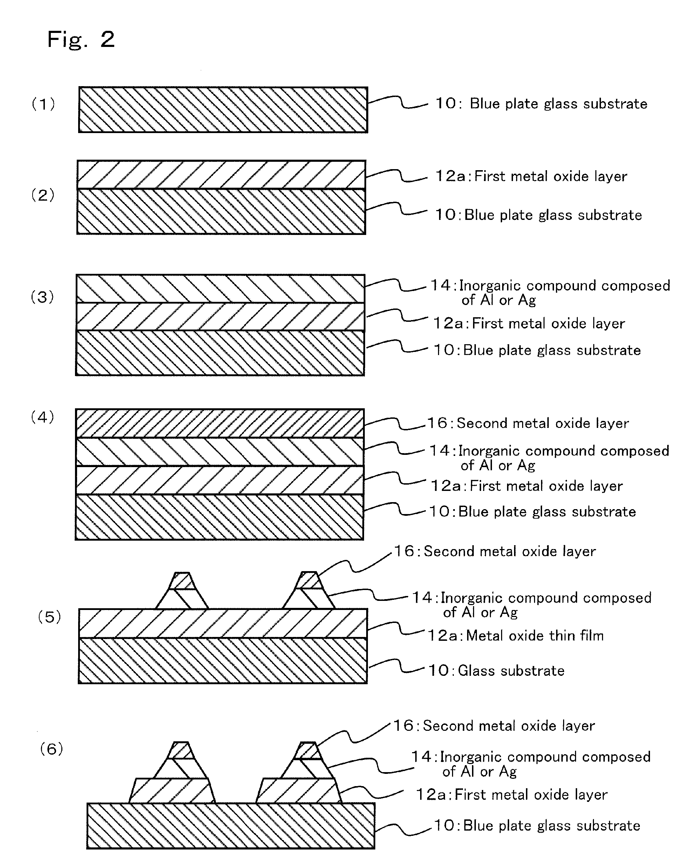

A first metal oxide layer 12a and an inorganic compound layer 14 were formed in the same manner as in Example 1-1 except that the first target was changed to a second target composed of indium oxide-tin oxide-cerium oxide (In/ (In+Sn) = 90 atomic %, Ce/ (In+Sn+Ce) = 4.9 atomic %) and that Ag-Pd-Cu (98.5: 0.5: 1.0 wt%) was changed to Ag-Au-Ni (98.5: 0.5: 1.0 wt%) (see Figs. 2(1) to 2(3)). It is to be noted that the first metal oxide layer 12a of Example 1-2, that is, the first metal oxide layer 12a shown in Fig. 2(2) corresponds to the metal oxide layer 12 shown in Fig. 1(2).

Next, a second metal oxide layer 16 was formed as a protection film by the use of a third target composed of indium oxide and zinc oxide (In/ (In+Zn) = 75 atomic %) at room temperature (see Fig. 2(4)). The thickness of the second metal oxide layer 16 was 20 nmm.

Next, etching was carried out in the same manner as in Example 1-1 to manufacture a semi-transparent semi-reflective electrode substrate (see Figs. 2(5) and 2(6)). The specific resistance of the first metal oxide layer 12a was 320 µΩcm, and the electrode resistance was 0.61 kΩ.

The thus obtained semi-transparent semi-reflective electrode substrate had low electric resistance. The surface of the substrate was observed with a scanning electron microscope, and as a result no surface roughness was observed on the metal oxide layer 12a. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 30 wt% of phosphate ions, 1.5 wt% of nitrate ions, and 40 wt% of acetate ions at a temperature of 30°C was used as an etchant, the ratio of the etching rate of the inorganic compound layer 14 to that of the first metal oxide layer 12a was 45.

Further, it is to be noted that in a case where an aqueous solution containing 30 wt% of phosphate ions, 1. 5 wt% of nitrate ions, and 40 wt% of acetate ions at a temperature of 30°C was used as an etchant, the ratio of the etching rate of the inorganic compound layer 14 to that of the second metal oxide layer 16 was 1.5.

### (Example 1-3)

A metal oxide layer 12 and an inorganic compound layer 14 were formed in the same manner as in Example 1-1 except that the first target was changed to a fourth target composed of indium oxide-tin oxide-praseodymium oxide (In/ (In+Sn) = 90 atomic %, Pr/ (In+Sn+Pr) = 4.6 atomic %) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the metal oxide layer 12 was 450 µΩcm.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 30 wt% of phosphate ions, 1.5 wt% of nitrate ions, and 40 wt% of acetate ions at a temperature of 30°C was used as an etchant, the ratio of the etching rate of the inorganic compound layer 14 to that of the metal oxide layer 12 was 38.

### (Example 1-4)

A metal oxide layer 12 and an inorganic compound layer 14 were formed in the same manner as in Example 1-1 except that the first target was changed to a fifth target composed of indium oxide-tin oxide-neodymium oxide (In/ (In+Sn) = 90 atomic %, Nd/ (In+Sn+Nd) = 3.8 atomic %) and that Ag-Pd-Cu (98.5: 0.5: 1.0 wt%) was changed to Ag-Pt-Co (98.5: 0.5: 1.0 wt%) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the metal oxide layer 12 was 420 µΩcm, and the electrode resistance was 0.67 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 30 wt% of phosphate ions, 1.5 wt% of nitrate ions, and 40 wt% of acetate ions at a temperature of 30°C was used as an etchant, the ratio of the etching rate of the inorganic compound layer 14 to that of the metal oxide layer 12 was 48.

### (Example 1-5)

A metal oxide layer 12 and an inorganic compound layer 14 were formed in the same manner as in Example 1-1 except that the first target was changed to a sixth target composed of indium oxide-tin oxide-samarium oxide (In/ (In+Sn) = 90 atomic %, Sm/ (In+Sn+Sm) = 3.2 atomic %) and that Ag-Pd-Cu (98.5: 0.5: 1.0 wt%) was changed to Ag-Co-Ni (98.0: 1.0: 1.0 wt%) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the metal oxide layer 12 was 720 µΩcm, and the electrode resistance was 0.72 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 30 wt% of phosphate ions, 1.5 wt% of nitrate ions, and 40 wt% of acetate ions at a temperature of 30°C was used as an etchant, the ratio of the etching rate of the inorganic compound layer 14 to that of the metal oxide layer 12 was 40.

### (Example 1-6)

A metal oxide layer 12 and an inorganic compound layer 14 were formed in the same manner as in Example 1-1 except that the first target was changed to a seventh target composed of indium oxide-tin oxide-terbium oxide (In/ (In+Sn) = 90 atomic %, Tb/ (In+Sn+Tb) = 4.7 atomic %) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the metal oxide layer 12 was 1,450 µΩcm.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 30 wt% of phosphate ions, 1.5 wt% of nitrate ions, and 40 wt% of acetate ions at a temperature of 30°C was used as an etchant, the ratio of the etching rate of the inorganic compound layer 14 to that of the metal oxide layer 12 was 46.

### (Example 1-7)

First, a blue plate glass substrate 10 coated with SiO₂ was prepared (see Fig. 1(1)). On such a blue plate glass substrate 10, a metal oxide layer 12 was formed using the first target composed of indium oxide-cerium oxide (Ce/ (In+Ce) = 4.5 atomic %) (see Fig. 1(2)). In this regard, it is to be noted that the temperature of the blue plate glass substrate 10 at the time when the metal oxide layer 12 was formed was 200°C, the thickness of the metal oxide layer 12 was 75 nm, and the specific resistance of the metal oxide layer 12 was 380 µΩcm. Next, on the metal oxide layer 12, an inorganic compound layer 14 was formed using an Al target composed of Al-Nd (99: 1 wt%) (see Fig. 1 (3)). The thickness of the inorganic compound layer 14 was 100 nm. It is to be noted that the metal oxide layer 12 and the inorganic compound layer 14 containing Al as a main ingredient are collectively called an electrode layer.

It is to be noted that semi-transparent semi-reflective electrode substrates according to Examples 1-7 to 1-11 were manufactured in substantially the same manner as in Example 1-1 except that the main ingredient of the metal oxide layer 12 was changed from Ag to Al.

Next, the inorganic compound layer 14 was subjected to etching. After the completion of etching, residual portions were provided as a plurality of lines of the inorganic compound layer 14 (see Fig. 1(4)).

A mask pattern used for etching was designed such that the width of each of the lines of the inorganic compound layer 14 became 40 µm and the space between the adjacent lines of the inorganic compound layer 14 became 70 µm.

Etching of the inorganic compound layer 14 was carried out in the following manner using the mask pattern described above. First, a resist was applied onto the inorganic compound layer 14. A glass plate having the mask pattern was placed on the resist, and then the resist was exposed to light, developed, and post-baked.

Next, the inorganic compound layer 14 was subjected to etching using an aqueous solution containing 50 wt% of phosphate ions, 2.0 wt% of nitrate ions, and 40 wt% of acetate ions so that the over etching time became 100% of the just etching time (see Fig. 1(4)). It is to be noted that the aqueous solution is one example of an etchant λ claimed in the present invention.

Next, the blue plate glass substrate 10 which had been subjected to etching was washed with water, and was then dried.

Next, the metal oxide layer 12 was subjected to etching. After the completion of etching, residual portions were provided as a plurality of lines of the metal oxide layer 12 (see Fig. 1(5)).

A mask pattern used for etching the metal oxide layer 12 was designed such that the width of each of the lines of the metal oxide layer 12 became 90 µm and the space between the adjacent lines of the metal oxide layer 12 became 20 µm.

Etching of the metal oxide layer 12 was carried out in the following manner using the mask pattern described above. First, a resist was applied onto the electrode layer. A glass plate having the mask pattern was placed on the resist, and then the resist was exposed to light, developed, and post-baked (see Fig. 1(5)). In this regard, it is to be noted that exposure of the resist was carried out in such a manner that one of the side edges of each line of the inorganic compound layer 14 and one of the side edges of each line of the metal oxide layer 12 were overlapped one another.

Next, the metal oxide layer 12 was subjected to etching using a 4 wt% aqueous oxalic acid solution. It is to be noted that the aqueous solution is one example of an etchant σ claimed in the present invention. After the resist was removed, the resistance of one of the electrodes having a length of 5 cm was measured and was found to be 0.65 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that in a case where an aqueous solution containing 50 wt% of phosphate ions, 2.0 wt% of nitrate ions, and 40 wt% of acetate ions at a temperature of 30°C was used as an etchant, the ratio of the etching rate of the inorganic compound layer 14 to that of the metal oxide layer 12 was 16.

### (Example 1-8)

A first metal oxide layer 12a and an inorganic compound layer 14 were formed in the same manner as in Example 1-7 except that the first target was changed to the second target composed of indium oxide-tin oxide-cerium oxide (In/ (In+Sn) = 90 atomic %, Ce/ (In+Sn+Ce) = 4.9 atomic %) and that Al-Nd (99: 1 wt%) was changed to Al-Pt (99: 1 wt%) (see Figs. 2(1) to 2(3)). It is to be noted that the first metal oxide layer 12a of Example 1-8, that is, the first metal oxide layer 12a shown in Fig. 2(2) corresponds to the metal oxide layer 12 shown in Fig. 1(2).

Next, a second metal oxide layer 16 was formed as a protection film by the use of a target 3 composed of indium oxide and zinc oxide (In/ (In+Zn) = 85 atomic %) at room temperature (see Fig. 2 (4)). The thickness of the second metal oxide layer 16 was 20 nmm.

Next, etching was carried out in the same manner as in Example 1-1 to manufacture a semi-transparent semi-reflective electrode substrate (see Figs. 2(5) and 2(6)). The specific resistance of the indium oxide-tin oxide-cerium oxide layer was 320 µΩcm, and the electrode resistance was 1.57 kΩ.

The thus obtained semi-transparent semi-reflective electrode substrate had low electric resistance. The surface of the substrate was observed with a scanning electron microscope, and as a result no surface roughness was observed on the metal oxide layer 12a. In addition, changes in the edges of the inorganic compound layer 14 were hardly seen before and after etching with oxalic acid. This means that the inorganic compound layer 14 was hardly etched with an etchant σ containing oxalic acid.

It is to be noted that the ratio of the etching rate of the inorganic compound layer 14 to that of the first metal oxide layer 12a was 18, and that the ratio of the etching rate of the inorganic compound layer 14 to that of the second metal oxide layer 16 was 1.1.

### (Example 1-9)

A metal oxide layer 12 and an inorganic compound layer 14 were formed in the same manner as in Example 1-7 except that the first target was changed to the fourth target composed of indium oxide-tin oxide-praseodymium oxide (In/ (In+Sn) = 90 atomic %, Pr/ (In+Sn+Pr) = 4.6 atomic %) (see Figs. 1(1) to 1 (3)).

Next, etching was carried out in the same manner as in Example 1-1 to manufacture a semi-transparent semi-reflective electrode substrate (see Figs. 1(4) and 1(5)). The specific resistance of the metal oxide layer 12 was 450 µΩcm, and the electrode resistance was 1.66 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that the ratio of the etching rate of the inorganic compound layer 14 to that of the metal oxide layer 12 was 15.

### (Example 1-10)

A metal oxide layer 12 and an inorganic compound layer 14 were formed in the same manner as in Example 1-7 except that the first target was changed to the fifth target composed of indium oxide-tin oxide-neodymium oxide (In/ (In+Sn) = 90 atomic%, Nd/ (In+Sn+Nd) = 3.8 atomic %) and that Al-Nd (99: 1 wt%) was changed to Al-Au (99: 1 wt%) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the indium oxide-tin oxide-neodymium oxide layer was 420 µΩcm, and the electrode resistance was 1.39 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that the ratio of the etching rate of the inorganic compound layer 14 to that of the metal oxide layer 12 was 18.

### (Example 1-11)

A metal oxide layer 12 and an inorganic compound layer 14 were formed in the same manner as in Example 1-7 except that the first target was changed to the sixth target composed of indium oxide-tin oxide-samarium oxide (In/ (In+Sn) = 90 atomic %, Sm/ (In+Sn+Sm) = 3.2 atomic %) and that Al-Nd (99: 1 wt%) was changed to Al (100 wt%) (see Figs. 1(1) to 1(3)).

Next, etching was carried out in the same manner as in Example 1-1 to manufacture a semi-transparent semi-reflective electrode substrate (see Figs. 1(4) and 1(5)). The specific resistance of the indium oxide-tin oxide-samarium oxide layer was 720 µΩcm, and the electrode resistance was 1.47 kΩ.

The thus obtained semi-transparent semi-reflective electrode substrate had low electric resistance. The surface of the substrate was observed with a scanning electron microscope, and as a result no surface roughness was observed on the metal oxide layer 12. In addition, changes in the edges of the inorganic compound layer 14 were hardly seen before and after etching with oxalic acid. This means that the inorganic compound layer 14 was hardly etched with an etchant σ containing oxalic acid.

It is to be noted that the ratio of the etching rate of the inorganic compound layer 14 to that of the metal oxide layer 12 was 20.

### (Comparative Example 1-1)

A metal oxide layer 12 and an inorganic compound layer 14 were formed in the same manner as in Example 1-1 except that the first target was changed to the seventh target composed of indium oxide-tin oxide (In/ (In+Sn) = 90 atomic %).

Next, etching was carried out in the same manner as in Example 1-1 to manufacture a semi-transparent semi-reflective electrode substrate. The specific resistance of the indium oxide-tin oxide layer was 250 µΩcm.

Surface roughness due to the etchant was hardly observed on the thus obtained semi-transparent semi-reflective electrode substrate. However, it was impossible to etch the metal oxide layer 12 with oxalic acid.

### (Comparative Example 1-2)

A metal oxide layer 12 and an inorganic compound layer 14 were formed in the same manner as in Example 1-1 except that the first target was changed to the eighth target composed of indium oxide-zinc oxide (In/ (In+Zn) = 85 atomic %).

Next, etching was carried out in the same manner as in Example 1-1 to manufacture a semi-transparent semi-reflective electrode substrate. The specific resistance of the indium oxide-zinc oxide layer was 390 µΩcm.

In this case, the indium oxide-zinc oxide layer was also etched when Ag was etched.

### (Summary of the first embodiment)

As described above, according to the present invention, it is possible to avoid a repetition of complicated operations by using an etchant which enables selective etching, that is, by using an etchant having different etching rates for different layers, thereby simplifying the manufacturing processes of a semi-transparent semi-reflective electrode substrate and shortening the manufacturing time thereof. Therefore, it is possible to efficiently provide a semi-transparent semi-reflective electrode substrate.

### Second Embodiment

Hereinbelow, a preferred second embodiment according to the present invention will be described. It is to be noted that in the present invention, the word "batch etching" means that an inorganic compound layer and a metal oxide layer are subjected to etching at a time with a single etchant.

### (Example 2-1)

### (a) Inorganic compound layer and metal oxide layer

(1) Formation of inorganic compound layer and measurement of etching rate
   A blue plate glass substrate coated with SiO₂ was placed in a DC magnetron sputtering system (manufactured by Anelva Corporation), and the blue plate glass substrate was heated to 200°C. Then, sputtering was carried out using an Al target (Al: 100 atomic %) to form an inorganic compound layer having a thickness of 100 nm on the blue plate glass substrate.
   An etchant containing phosphoric acid (40 wt%), nitric acid (2.5 wt%), and acetic acid (40 wt%) (hereinafter, simply referred to as an "etchant (I)") was prepared, and then the inorganic compound layer provided on the blue plate glass substrate was subjected to etching with the etchant (I) at 30°C. At this time, the etching rate A (I) of the inorganic compound layer was measured, and was found to be 42 nm/min.
   On the other hand, another etchant containing phosphoric acid (55 wt%), nitric acid (2.5 wt%), and acetic acid (40 wt%) (hereinafter, simply referred to as an "etchant (II)") was prepared, and then the inorganic compound layer provided on another blue plate glass substrate was subjected to etching with the etchant (II) at 30°C. At this time, the etching rate A (II) of the inorganic compound layer was measured, and was found to be 73 nm/min.
(2) Formation of metal oxide layer and measurement of etching rate
   In the same manner as in (a)(1) described above, a blue plate glass substrate coated with SiO₂ was placed in the DC magnetron sputtering system, and the blue plate glass substrate was heated to 200°C. Then, sputtering was carried out using an indium oxide-zinc oxide target ([In]: [Zn]= 83.0: 17.0 atomic %) to form a metal oxide layer having a thickness of 75 nm on the blue plate glass substrate.
   The metal oxide layer provided on the blue plate glass substrate was subjected to etching with the etchant (I) at 30°C. At this time, the etching rate B (I) of the metal oxide layer was measured, and was found to be 41 nm/min.
   On the other hand, the metal oxide layer provided on another blue plate glass substrate was subjected to etching with the etchant (II) at 30°C. At this time, the etching rate B (II) of the metal oxide layer was measured, and was found to be 42 nm/min.
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), and B(II) measured in (a) (1) and (a) (2). As a result, B(I)/A(I) was 0.98 and B(II)/A(II) was 0.58 (see Table 2-1).
(4) Measurement of work function and specific resistance of metal oxide layer
   The metal oxide layer provided on the blue plate glass substrate was cleaned by the application of X rays. Then, the work function of the metal oxide layer was measured with a photoelectron spectrometer ("AC-1" manufactured by Riken Keiki Co., Ltd.), and was found to be 5.24 eV (see Table 2-2). Further, the specific resistance of the metal oxide layer was measured with a resistivity meter ("Loresta" manufactured by Mitsubishi Yuka K.K.), and was found to be 340 µ·Ω·cm (see Table 2-2).

### (b) Reflective electrode substrate

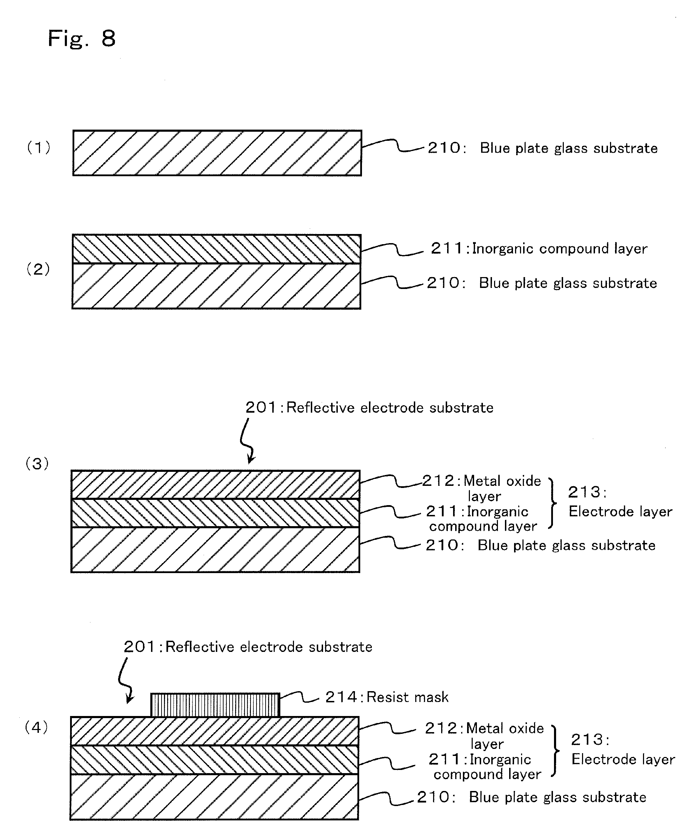

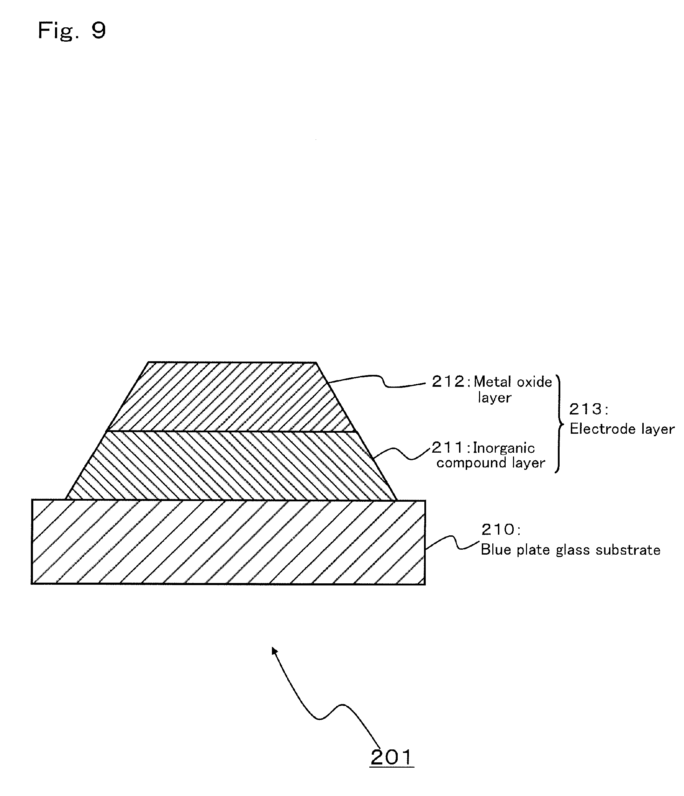

(1) Manufacture of reflective electrode substrate
   As shown in Fig. 8(1), in the same manner as in (a)(1), a blue plate glass substrate 210 coated with SiO₂ was placed in the DC magnetron sputtering system, and the blue plate glass substrate 210 was heated to 200°C. As shown in Fig. 8(2), sputtering was carried out using an Al target (Al: 100 atomic %) to form an inorganic compound layer 211 having a thickness of 100 nm on the blue plate glass substrate 210. As shown in Fig. 8(3), sputtering was then carried out using an indium oxide-zinc oxide target ([In]: [Zn] = 83.0: 17.0 atomic %) to form a metal oxide layer 212 having a thickness of 20 nm on the inorganic compound layer 211 provided on the blue plate glass substrate 210. In this way, an electrode layer 213 composed of the inorganic compound layer 211 and the metal oxide layer 212 was formed on the blue plate glass substrate 210 to manufacture a reflective electrode substrate 201. The surface resistivity of the reflective electrode substrate 201 was measured with a surface resistivity meter similar to the resistivity meter used in (a)(4), and was found to be 1.2 Ω/□ (see Table 2-2)
(2) Analysis of etching characteristics of reflective electrode substrate
   Onto the metal oxide layer 212 of the reflective electrode substrate 201, a resist ("NPR2048USP" manufactured by Nippon Polytech Corporation) was applied, and then the resist was exposed to X rays through a photomask. After development, the resist was heated to 130°C, and was then post-baked for 15 minutes. In this way, a resist mask 214 was formed on the metal oxide layer 212 (see Fig. 8(4)).
   The inorganic compound layer 211 and the metal oxide layer 212 of the reflective electrode substrate 201 were subjected to batch etching using the etchant (I) and the etchant (II) to obtain a reflective electrode substrate 201 as shown in Fig. 9.
   The etched surface of the inorganic compound layer 211 and the etched surface of the metal oxide layer 212 were observed with a scanning electron microscope ("S800" manufactured by Hitachi Ltd.). As a result, no residue was left on the etched surfaces, and the etched surfaces were smooth with no steps. Further, the inorganic compound layer 211 and the metal oxide layer 212 were well etched in accordance with the pattern of the resist mask 214 (see Table 2-2).

### (Examples 2-2 to 2-14)

### (a) Inorganic compound layer and metal oxide layer

(1) Formation of inorganic compound layer and measurement of etching rate
   In the same manner as in Example 2-1 (a)(1), an inorganic compound layer was formed on a blue plate glass substrate, and then the etching rates A(I) and A(II) of the inorganic compound layer were measured. The etching rates A (I) and A(II) were the same as those measured in Example 2-1 (a)(1).
(2) Formation of metal oxide layer and measurement of etching rate
   A metal oxide layer was formed on a blue plate glass substrate in the same manner as in Example 2-1 (a) (2) except that the indium oxide-zinc oxide target ([In]: [Zn] = 83.0: 17.0 atomic %) was changed to a target with the composition shown in Table 2-1.
   As shown in Table 2-1, targets used in Examples 2-2 to 2-14 are slightly different from each other. Specifically, each of the targets used in Examples 2-2 to 2-14 contains a lanthanoid group metal element as a third element in addition to indium and zinc. The composition of each of the targets used in Examples 2-2 to 2-14 is expressed in terms of atomic % in Table 2-1. Therefore, Examples 2-2 to 2-14 are different from each other in the composition of a target for use in sputtering the metal oxide layer. In each of Examples 2-2 to 2-14, the physical properties of the metal oxide layer were measured.
   The metal oxide layer provided on the blue plate glass substrate was subjected to etching with the etchant (I) at 30°C. At this time, the etching rate B (I) of the metal oxide layer was measured. On the other hand, the metal oxide layer provided on another blue plate glass substrate was subjected to etching with the etchant (II) at 30°C. At this time, the etching rate B (II) of the metal oxide layer was measured.
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), andB(II) measured in (a) (1) and (a) (2). The calculation results are shown in Table 2-1.
(4) Measurement of work function and specific resistance of metal oxide layer
   In the same manner as in Example 2-1 (a)(4), the metal oxide layer provided on the blue plate glass substrate was cleaned by the application of X rays, and then the work function and the specific resistance of the metal oxide layer were measured. The measurement results are shown in Table 2-2.

### (b) Reflective electrode substrate

(1) Manufacture of reflective electrode substrate
   In each of Examples 2-2 to 2-14, an inorganic compound layer 211 and a metal oxide layer 212 were formed on a blue plate glass substrate 210 in the same manner as in Example 2-1 (b) (1) except that the indium oxide-zinc oxide target ([In]: [Zn] = 83.0: 17.0 atomic %) used for sputtering was changed to a target with the composition shown in Table 2-1 (see Fig. 8(3)). In this way, a reflective electrode substrate 201 having an electrode layer 213 composed of the inorganic compound layer 211 and the metal oxide layer 212 was manufactured. The surface resistivity of the reflective electrode substrate 201 was measured with a surface resistivity meter similar to the resistivity meter used in Example 2-1 (see Table 2-2).
   In each of Examples 2-2 to 2-14, a resist mask 214 was formed on the metal oxide layer 212 of the reflective electrode substrate 201 in the same manner as in Example 2-1 (b) (2) (see Fig. 8(4)). Then, the inorganic compound layer 211 and the metal oxide layer 212 of the reflective electrode substrate 201 were subjected to batch etching using the etchant (I) and the etchant (II) to obtain a reflective electrode substrate 201 as shown in Fig. 9.
(2) Analysis of etching characteristics of reflective electrode substrate

The etched surface of the inorganic compound layer 211 and the etched surface of the metal oxide layer 212 were observed with the same scanning electron microscope as used in Example 2-1. As a result, in all the reflective electrode substrates of Examples 2-2 to 2-14 , no residue was lefton the etched surfaces, and the etched surfaces were smooth with no steps. Further, the inorganic compound layer 211 and the metal oxide layer 212 were well etched in accordance with the pattern of the resist mask 214 (see Table 2-2).

**Table 2-1**

| Examples | Composition of target | | | | Etching rate ratio | |
|---|---|---|---|---|---|---|
| | Inorganic compound layer | Metal oxide layer | | | B(I)/A(I) *) | B(II)/A(II) **) |
| | Al (atomic %) | [In] (atomic %) | [Zn] (atomic %) | Third ingredient (atomic %) | | |
| 2-1 | 100 | 83. 0 | 17. 0 | | 0. 98 | 0. 58 |
| 2-2 | 100 | 80. 7 | 14. 4 | [Ce] (4. 9) | 0. 99 | 0. 58 |
| 2-3 | 100 | 74. 0 | 11. 5 | [Pr] (14. 5) | 1. 01 | 0. 62 |
| 2-4 | 100 | 84. 1 | 14. 8 | [Nd](1. 1) | 1. 02 | 0. 59 |
| 2-5 | 100 | 81. 6 | 14. 7 | [Sm](3. 7) | 1. 00 | 0. 60 |
| 2-6 | 100 | 82. 5 | 14. 9 | [Eu](2. 6) | 1. 00 | 0. 61 |
| 2-7 | 100 | 83. 3 | 14. 5 | [Gd] (1. 2) | 1. 07 | 0. 66 |
| 2-8 | 100 | 79. 0 | 14. 3 | [Tb] (6. 7) | 1. 00 | 0. 62 |
| 2-9 | 100 | 72. 0 | 15. 0 | [Dy](13. 9) | 1. 00 | 0. 62 |
| 2-10 | 100 | 78. 2 | 15. 2 | [Ho] (6. 6) | 1. 02 | 0. 62 |
| 2-11 | 100 | 78. 0 | 1 6. 7 | [Er] (5. 3) | 1. 02 | 0. 62 |
| 2-12 | 100 | 77. 0 | 17. 7 | [Tm] (5. 3) | 1. 02 | 0. 62 |
| 2-13 | 100 | 79. 8 | 16. 8 | [Yb] (3. 4) | 1. 02 | 0. 62 |
| 2-14 | 100 | 82. 5 | 14. 7 | [Lu] (2. 8) | 1. 02 | 0. 62 |

| | | | | | | |
|---|---|---|---|---|---|---|
| *) A(I) : A(I) represents the etching rate of the inorganic compound layer with the etchant (I) containing phosphate ions (40 wt%), nitrate ions (2.5 wt%), and acetate ions (40 wt%) at 30oC. B(I) : B(I) represents the etching rate of the metal oxide layer with the etchant (I) containing phosphate ions (40 wt%), nitrate ions (2.5 wt%), and acetate ions (40 wt%) at 30°C. | | | | | | |
| **) A (II): A(II) represents the etching rate of the inorganic compound layer with the etchant (II) containing phosphate ions (55 wt%). nitrate ions (2.5 wt%), and acetate ions (40 wt%) at 30°C. B(II): B(II) represents the etching rate of the metal oxide layer with the etchant (II) containing phosphate ions (55 wt%), nitrate ions (2.5 wt%), and acetate ions (40 wt%) at 30°C. | | | | | | |

**Table 2-2**

| Examples | Metal oxide layer | | Reflective electrode substrate | |
|---|---|---|---|---|
| | Work function (eV) | Specific resistance (µΩcm) | Surface resistivity (Ω/□) | Etched surface condition |
| 2-1 | 5. 24 | 340 | 1. 2 | Good |
| 2-2 | 5. 92 | 960 | 1. 2 | Good |
| 2-3 | 5. 88 | 860 | 1. 2 | Good |
| 2-4 | 5. 61 | 650 | 1. 2 | Good |
| 2-5 | 5. 74 | 480 | 1. 2 | Good |
| 2-6 | 5. 68 | 730 | 1. 2 | Good |
| 2-7 | 5. 60 | 530 | 1. 2 | Good |
| 2-8 | 5. 63 | 1950 | 1. 2 | Good |
| 2-9 | 5. 58 | 980 | 1. 2 | Good |
| 2-10 | 5. 56 | 475 | 1. 2 | Good |
| 2-11 | 5. 48 | 460 | 1. 2 | Good |
| 2-12 | 5. 28 | 420 | 1. 2 | Good |
| 2-13 | 5. 34 | 455 | 1. 2 | Good |
| 2-14 | 5. 28 | 41 5 | 1. 2 | Good |

### (Example 2-15)

### (a) Inorganic compound layer and metal oxide layer

(1) Formation of inorganic compound layer and measurement of etching rate
   An inorganic compound layer was formed on a blue plate glass substrate in the same manner as in Example 2-1 (a) (1) except that the Al target (Al: 100 atomic %) used for sputtering was changed to an Al-Au target ([Al]: [Au] = 99: 1 atomic %).
   The inorganic compound layer provided on the blue plate glass substrate was subjected to etching with the etchant (I) at 30°C. At this time, the etching rate A (I) of the inorganic compound layer was measured, and was found to be 38 nm/min. On the other hand, the inorganic compound layer provided on another blue plate glass substrate was subjected to etching with the etchant (II) at 30°C. At this time, the etching rate A (II) of the inorganic compound layer was measured, and was found to be 71 nm/min.
(2) Formation of metal oxide layer and measurement of etching rate, work function, and specific resistance
   In the same manner as in Example 2-1 (a) (2), a metal oxide layer was formed on a blue plate glass substrate, and then the etching rates B(I) and B(II) of the metal oxide layer were measured. The measurement results were the same as those measured in Example 2-1 (a) (2). Further, in the same manner as in Example 1-2 (a) (4), the work function and the specific resistance of the metal oxide layer were measured. The measurement results were the same as those measured in Example 1-2 (a)(4).
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), and B(II) measured in (a) (1) and (a) (2). As a result, B(I)/A(I) was 1.08, and B(II)/A(II) was 0.59 (see Table 2-3).

### (b) Reflective electrode substrate

(1) Manufacture of reflective electrode substrate An inorganic compound layer 211 and a metal oxide layer 212 were formed on a blue plate glass substrate 210 in the same manner as in Example 2-1 (b) (1) except that the Al target (Al: 100 atomic %) used for sputtering was changed to an Al-Au target ([Al]: [Au] = 99 : 1 atomic %). In this way, a reflective electrode substrate 201 having an electrode layer 213 composed of the inorganic compound layer 211 and the metal oxide layer 212 was manufactured (see Fig. 8(3)). The surface resistivity of the reflective electrode substrates 201 was measured with a surface resistivity meter similar to that used in Example 2-1 (b)(1), and was found to be 1.2 Ω/□ (see Table 2-3).
   A resist mask 214 was formed on the metal oxide layer 212 of the reflective electrode substrate 201 in the same manner as in Example 2-1 (b) (2) (see Fig. 8(4)). Then, the inorganic compound layer 211 and the metal oxide layer 212 of the reflective electrode substrate 201 were subjected to batch etching using the etchant (I) and the etchant (II) to obtain a reflective electrode substrate 201 as shown in Fig. 9.
(2) Analysis of etching characteristics of reflective electrode substrate
   The etched surface of the inorganic compound layer 211 and the etched surface of the metal oxide layer 212 were observed with the same scanning electron microscope as used in Example 2-1 (b)(2). As a result, no residue was left on the etched surfaces, and the etched surfaces were smooth with no steps. Further, the inorganic compound layer 211 and the metal oxide layer 212 were well etched in accordance with the pattern of the resist mask 214 (see Table 2-3).

### (Example 2-16)

### (a) Inorganic compound layer and metal oxide layer

(1) Formation of inorganic compound layer and measurement of etching rate
   An inorganic compound layer was formed on a blue plate glass substrate in the same manner as in Example 2-1 (a) (1) except that the Al target (Al: 100 atomic %) used for sputtering was changed to an Al-Pt target ([Al]: [Pt] = 99: 1 atomic %).
   The inorganic compound layer provided on the blue plate glass substrate was subjected to etching with the etchant (I) at 30°C. At this time, the etching rate A (I) of the inorganic compound layer was measured, and was found to be 39 nm/min. On the other hand, the inorganic compound layer provided on another blue plate glass substrate was subjected to etching with the etchant (II) at 30°C. At this time, the etching rate A (II) of the inorganic compound layer was measured, and was found to be 69 nm/min.
(2) Formation of metal oxide layer and measurement of etching rate, work function, and specific resistance
   In the same manner as in Example 2-1 (a) (2), a metal oxide layer was formed on a blue plate glass substrate, and then the etching rates B(I) and B(II) of the metal oxide layer were measured. The measurement results were the same as those measured in Example 2-1 (a) (2). Further, in the samemanner as in Example 2-1 (a) (4), the work function and the specific resistance of the metal oxide layer were measured. The measurement results were the same as those measured in Example 2-1 (a)(4).
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), and B(II) measured in (a) (1) and (a) (2). As a result, B(I)/A(I) was 1.05, and B(II)/A(II) was 0.61 (see Table 2-3).

### (b) Reflective electrode substrate

(1) Manufacture of reflective electrode substrate
   An inorganic compound layer 211 and a metal oxide layer 212 were formed on a blue plate glass substrate 210 in the same manner as in Example 2-1 (b)(1) except that the Al target (Al: 100 atomic %) used for sputtering was changed to an Al-Pt target ([Al] : [Pt] = 99: 1 atomic %) . In this way, a reflective electrode substrate 201 having an electrode layer 213 composed of the inorganic compound layer 211 and the metal oxide layer 212 was manufactured (see Fig. 8(3)). The surface resistivity of the reflective electrode substrates 201 was measured with a surface resistivity meter similar to that used in Example 2-1 (b)(1), and was found to be 1.2 Ω/□ (see Table 2-3).
   A resist mask 214 was formed on the metal oxide layer 212 of the reflective electrode substrate 201 in the same manner as in Example 2-1 (b) (2) (see Fig. 8(4)). Then, the inorganic compound layer 211 and the metal oxide layer 212 of the reflective electrode substrate 201 were subjected to batch etching using the etchant (I) and the etchant (II) to obtain a reflective electrode substrate 201 as shown in Fig. 9.
(2) Analysis of etching characteristics of reflective electrode substrate
   The etched surface of the inorganic compound layer 211 and the etched surface of the metal oxide layer 212 were observed with the same scanning electron microscope as used in Example 2-1 (b)(2). As a result, no residue was left on the etched surfaces, and the etched surfaces were smooth with no steps. Further, the inorganic compound layer 211 and the metal oxide layer 212 were well etched in accordance with the pattern of the resist mask 214 (see Table 2-3).

### (Example 2-17)

### (a) Inorganic compound layer and metal oxide layer

(1) Formation of inorganic compound layer and measurement of etching rate
   An inorganic compound layer was formed on a blue plate glass substrate in the same manner as in Example 2-1 (a) (1) except that the Al target (Al: 100 atomic %) used for sputtering was changed to an Al-Nd target ([Al]: [Nd] = 99: 1 atomic %).
   The inorganic compound layer provided on the blue plate glass substrate was subjected to etching with the etchant (I) at 30°C. At this time, the etching rate A (I) of the inorganic compound layer was measured, and was found to be 41 nm/min. On the other hand, the inorganic compound layer provided on another blue plate glass substrate was subjected to etching with the etchant (II) at 30°C. At this time, the etching rate A (II) of the inorganic compound layer was measured, and was found to be 71 nm/min.
(2) Formation of metal oxide layer and measurement of etching rate, work function, and specific resistance
   In the same manner as in Example 2-1 (a) (2), a metal oxide layer was formed on a blue plate glass substrate, and then the etching rates B(I) and B(II) of the metal oxide layer were measured. The measurement results were the same as those measured in Example 2-1 (a) (2). Further, in the samemanner as in Example 2-1 (a) (4), the work function and the specific resistance of the metal oxide layer were measured. The measurement results were the same as those measured in Example 2-1 (a)(4).
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), and B(II) measured in (a)(1) and (a) (2). As a result, B(I)/A(I) was 1.00 and B(II)/A(II) was 0.59 (see Table 2-3).

### (b) Reflective electrode substrate

(1) Manufacture of reflective electrode substrate
   An inorganic compound layer 211 and a metal oxide layer 212 were formed on a blue plate glass substrate 210 in the same manner as in Example 2-1 (b) (1) except that the Al target (Al: 100 atomic %) used for sputtering was changed to an Al-Nd target ([Al] : [Nd] = 99 : 1 atomic %). In this way, a reflective electrode substrate 201 having an electrode layer 213 composed of the inorganic compound layer 211 and the metal oxide layer 212 was manufactured (see Fig. 8(3)). The surface resistivity of the reflective electrode substrates 201 was measured with a surface resistivity meter similar to that used in Example 2-1 (b)(1), and was found to be 1.2 Ω/□ (see Table 2-3).
   A resist mask 214 was formed on the metal oxide layer 212 of the reflective electrode substrate 201 in the same manner as in Example 2-1 (b) (2) (see Fig. 8(4)). Then, the inorganic compound layer 211 and the metal oxide layer 212 of the reflective electrode substrate 201 were subjected to batch etching using the etchant (I) and the etchant (II) to obtain a reflective electrode substrate 201 as shown in Fig. 9.
(2) Analysis of etching characteristics of reflective electrode substrate
   The etched surface of the inorganic compound layer 211 and the etched surface of the metal oxide layer 212 were observed with the same scanning electron microscope as used in Example
2-1 (b)(2). As a result, no residue was left on the etched surfaces, and the etched surfaces were smooth with no steps. Further, the inorganic compound layer 211 and the metal oxide layer 212 were well etched in accordance with the pattern of the resist mask 214 (see Table 2-3).

**Table 2-3**

| Examples | Composition of target | | | | Reflective electrode substrate | | Etching rate ratio | |
|---|---|---|---|---|---|---|---|---|
| | Inorganic compound layer | | Metal oxide layer | | Surface resistivity (Ω/□) | Etched surface condition | B(I)/A(I)* | B(II)/A (II)* |
| | [Al] (atomic %) | Second ingredient (atomic %) | [In] (atomic %) | [Zn] (atomic %) | | | | |
| 2-15 | 99 | [Au](1) | 83.0 | 17.0 | 1.2 | Good | 1.08 | 0.59 |
| 2-16 | 99 | [Pt](1) | 83.0 | 17.0 | 1.2 | Good | 1.08 | 0.61 |
| 2-17 | 99 | [Nd](1) | 83.0 | 17.0 | 1.2 | Good | 1.08 | 0.59 |

| | | | | | | | | |
|---|---|---|---|---|---|---|---|---|
| *) A(I):A(I) represents the etching rate of the inorganic compound layer with the etchant (I) containing phosphoric acid (40 wt%), nitric acid (2.5 wt%), and acetic acid (40 wt%) at 30°C. B(I):B(I) represents the etching rate of the metal oxide layer with the etchant (I) containing phosphoric acid (40 wt%), nitric acid (2.5 wt%), and acetic acid (40 wt%) at 30°C. **) A(II):A(II) represents the etching rate of the inorganic compound layer with the etchant (II) containing phosphoric acid (55 wt%), nitric acid (2.5 wt%), and acetic acid (40 wt%) at 30°C. B(II):B(II) represents the etching rate of the metal oxide layer with the etchant (II) containing phosphoric acid (55 wt%), nitric acid (2.5 wt.%), and acetic acid (40 wt%) at 30°C. | | | | | | | | |

### (Comparative Example 2-1)

### (a) Inorganic compound layer and metal oxide layer

(1) Formation of inorganic compound layer and measurement of etching rate
   In the same manner as in Example 2-1 (a) (1), an inorganic compound layer was formed on a blue plate glass substrate, and then the etching rates A(I) and A(II) of the inorganic compound layer were measured. The measurement results were the same as those measured in Example 2-1 (a)(1).
(2) Formation of metal oxide layer and analysis of etching characteristics

A metal oxide layer was formed on a blue plate glass substrate in the same manner as in Example 2-1 (a) (2) except that the indium oxide-zinc oxide target ([In]: [Zn] = 83.0: 17.0 atomic %) used for sputtering was changed to an indium oxide-tin oxide target ([In] : [Sn] = 85.0: 15.0 atomic %) (see Table 2-4).

Then, in the same manner as in Example 2-1 (a)(4), the metal oxide layer was cleaned with X rays to measure the work function of the metal oxide layer. The work function of the metal oxide layer was 5.12 eV (see Table 2-5). Further, in the same manner as in Example 2-1 (a) (4), the specific resistance of the metal oxide layer was measured, and was found to be 210 µ·Ω·cm (see Table 2-5).

Next, the metal oxide layer provided on the blue plate glass substrate was subjected to batch etching using the etchant (I). On the other hand, the metal oxide layer provided on another blue plate glass substrate was subjected to batch etching using the etchant (II). In either case, the metal oxide layer was not dissolved (see Tables 2-4 and 2-5).

### (Comparative Example 2-2)

### (a) Inorganic compound layer and metal oxide layer

(1) Formation of inorganic compound layer and measurement of etching rate
   In the same manner as in Example 2-1 (a) (1), an inorganic compound layer was formed on a blue plate glass substrate, and then the etching rates A(I) and A(II) of the inorganic compound layer were measured. The measurement results were the same as those measured in Example 2-1 (a)(1).
(2) Formation of metal oxide layer and measurement of etching rate
   A metal oxide layer was formed on a blue plate glass substrate in the same manner as in Example 2-1 (a) (2) except that the indium oxide-zinc oxide target ([In] : [Zn] = 83.0: 17. 0 atomic %) used for sputtering was changed to an indium oxide-tin oxide-cerium oxide target ([In] : [Sn] : [Ce] = 85.0: 10.0: 5.0 atomic %).
   The metal oxide layer provided on the blue plate glass substrate was subjected to etching with the etchant (I) at 30°C. At this time, the etching rate B (I) of the metal oxide layer was measured, and was found to be 7.6 nm/min. On the other hand, the metal oxide layer provided on another blue plate glass substrate was subjected to etching with the etchant (II) at 30°C. At this time, the etching rate B (II) of the metal oxide layer was measured, and was found to be 5.1 nm/min.
(3) Calculation of etching rate ratio
   The ratio between the etching rate of the inorganic compound layer and that of the metal oxide layer, that is, B(I)/A(I) and B(II)/A(II) were calculated from the etching rates A(I), A(II), B(I), and B(II) measured in (a) (1) and (a) (2). As a result, B(I)/A(I) was 0.18 and B(II)/A(II) was 0.07 (see Table 2-4).
(4) Measurement of work function and specific resistance of metal oxide layer
   In the same manner as in Example 2-1 (a)(4), the metal oxide layer provided on the blue plate glass substrate was cleaned with X rays to measure the work function of the metal oxide layer. The work function of the metal oxide layer was 5.88 eV (see Table 2-5). Further, in the same manner as in Example 2-1 (a)(4), the specific resistance of the metal oxide layer was measured, and was found to be 780 µ·Ω·cm (see Table 2-5).

### (b) Reflective electrode substrate

(1) Manufacture of reflective electrode substrate
An inorganic compound layer 211 and a metal oxide layer 212 were formed on a blue plate glass substrate 210 in the same manner as in Example 2-1 (b) (1) except that the indium oxide-zinc oxide target ([In] : [Zn] = 87.0: 13.0 atomic %) used for sputtering was changed to an indium oxide-tin oxide-cerium oxide target ([In]: [Sn]: [Ce] = 85.0: 10.0: 5.0 atomic %) (see Table 2-4). In this way, a reflective electrode substrate 201 having an electrode layer 213 composed of the inorganic compound layer 211 and the metal oxide layer 212 was manufactured (see Fig. 8(3)).
In the same manner as in Example 2-1 (b) (2), a resist mask 214 was formed on the metal oxide layer 212 of the reflective electrode substrate 201 (see Fig. 8(4)). Then, the inorganic compound layer 211 and the metal oxide layer 212 of the reflective electrode substrate 201 were subjected to batch etching using the etchant (I) and the etchant (II).
(2) Analysis of etching characteristics of reflective electrode substrate
The etched surface of the inorganic compound layer 211 and the etched surface of the metal oxide layer 212 were observed with the same scanning electron microscope as used in Example 2-1. As a result, a large step was observed at the boundary between the inorganic compound layer 211 and the metal oxide layer 212 (see Table 2-5).

**Table 2-4**

| Comparative Examples | Composition of target | | | | Etching rate ratio | |
|---|---|---|---|---|---|---|
| | Inorganic compound layer | Metal oxide layer | | | B(I)/A(I)* | B(II)/A(II)* |
| | [Al] (atomic %) | [In] (atomic %) | [Sn] (atomic %) | Third ingredient (atomic %) | | |
| 2 - 1 | 100 | 85.0 | 15.0 | - | The metal oxide layer could not be etched. | |
| 2 - 2 | 100 | 85.0 | 10.0 | [Ce] (5.0) | 0.18 | 0.07 |

| | | | | | | |
|---|---|---|---|---|---|---|
| *) A(I):A(I) represents the etching rate of the inorganic compound layer with the etchant (I) containing phosphoric acid (40 wt%), nitric acid (2.5 wt%), and acetic acid (40 wt%) at 30°C. B(I):B(I) represents the etching rate of the metal oxide layer with the etchant (I) containing phosphoric acid (40 wt%), nitric acid (2.5 wt%), and acetic acid (40 wt%) at 30°C. **) A(II):A(II) represents the etching rate of the inorganic compound layer with the etchant (II) containing phosphoric acid (55 wt%), nitric acid (2.5 wt%), and acetic acid (40 wt%) at 30°C. B(II):B(II) represents the etching rate of the metal oxide layer with the etchant (II) containing phosphoric acid (55 wt%), nitric acid (2.5 wt%), and acetic acid (40 wt%) at 30°C. | | | | | | |

**Table 2-5**

| Comparative Examples | Work function (eV) | Specific resistance (µΩcm) | Etched surface condition |
|---|---|---|---|
| 2 - 1 | 5.12 | 210 | The metal oxide layer could not be etched. |
| 2 - 2 | 5.88 | 780 | The inorganic compound layer was over-etched so that a large step was produced. |

As described above, according to the manufacturing method of Comparative Example, it is difficult to carry out etching without producing a step at the boundary between the metal oxide layer and the inorganic compound layer. Therefore, it can be considered that it is also difficult to manufacture a reflective electrode substrate having a low specific resistance and a high work function by the manufacturing method according to Comparative Example. It is to be noted that all of the electrode layers of Examples 2-1 to 2-17 had a high reflectivity.

### (Summary of the second embodiment)

As described above, according to the manufacturing method of the present invention, it is possible to obtain a reflective electrode substrate having a low specific resistance and a high work function because the inorganic compound layer contains at least Al and the metal oxide layer contains at least indium oxide. Further, by using an etchant containing an etching composition composed of phosphoric acid, nitric acid, and acetic acid, it is also possible to subject the metal oxide layer and the inorganic compound layer to batch etching. In the thus obtained reflective electrode substrate according to the present invention, there is substantially no step at the boundary between the metal oxide layer and the inorganic compound layer, and there is little residue on the etched surface.

### Third Embodiment

Hereinbelow, a third embodiment according to the present invention will be described with reference to examples of the third embodiment. However, the present invention is not limited to these examples.

### (Example 3-1)

### (a) Formation of metal oxide layer and measurement of work function and specific resistance

(1) Formation of metal oxide layer
   A blue plate glass substrate coated with SiO₂ was prepared, and was heated to 200°C. Then, sputtering was carried out using an indium oxide-zinc oxide-cerium oxide target ([In]: [Zn] : [Ce] = 80.7: 14.4: 4.9 atomic %) to form a metal oxide layer having a thickness of 100 nm on the blue plate glass substrate.
(2) Measurement of work function and specific resistance of metal oxide layer
   The metal oxide layer provided on the blue plate glass substrate was cleaned by the application of X rays. Then, the work function of the metal oxide layer was measured with a photoelectron spectrometer ("AC-1" manufactured by Riken Keiki Co., Ltd.), and was found to be 5.92 eV (see Table 3-1) . Further, the specific resistance of the metal oxide layer was measured with a resistivity meter ("Loresta" manufactured by Mitsubishi Yuka K.K.), and was found to be 960 µ·Ω·cm (see Table 3-1).

### (b) Manufacture of reflective electrode substrate, measurement of surface resistivity, and analysis of etching characteristics

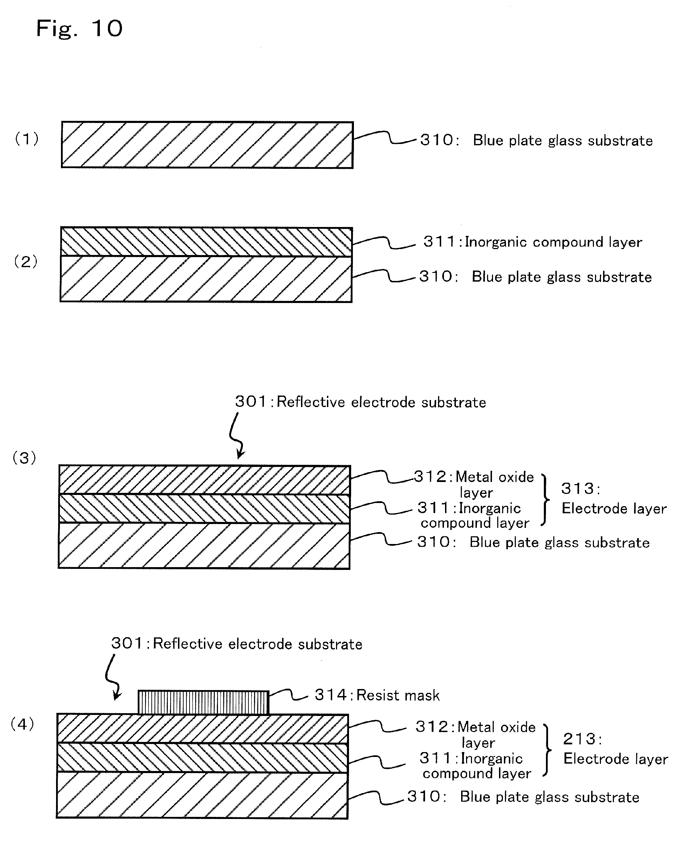

(1) Manufacture of reflective electrode substrate As shown in Fig. 10(1), in the same manner as in (a) (1), a blue plate glass substrate 310 coated with SiO₂ was heated to 200°C. Then, sputtering was carried out using an Ag target (Ag: 100 atomic %) to form an inorganic compound layer 311 having a thickness of 100 nm on the blue plate glass substrate 310 (see Fig. 10(2)). Next, sputtering was carried out using an indium oxide-zinc oxide-cerium oxide target ([In]: [Zn]: [Ce]= 80.7: 14.4: 4.9 atomic %) to form a metal oxide layer 312 having a thickness of 20 nm on the inorganic compound layer 311 provided on the blue plate glass substrate 310 (see Fig. 10 (3)). In this way, an electrode layer 313 composed of the inorganic compound layer 311 and the metal oxide layer 312 was formed on the blue plate glass substrate 310 to obtain a reflective electrode substrate 301.
(2) Measurement of surface resistivity
   The surface resistivity of the reflective electrode substrate 301 was measured with a surface resistivity meter similar to the resistivity meter used in (a) (2), and was found to be 1.2 Ω/□.
(3) Analysis of etching characteristics
   Onto the metal oxide layer 312 of the reflective electrode substrate 301, a resist ("NPR2048USP" manufactured by Nippon Polytech Corporation) was applied, and then the resist was exposed to X rays through a photomask. After development, the resist was heated to 130°C, and was then post-baked for 15 minutes. In this way, a resist mask 314 was formed on the metal oxide layer 312 (see Fig. 10(4)).

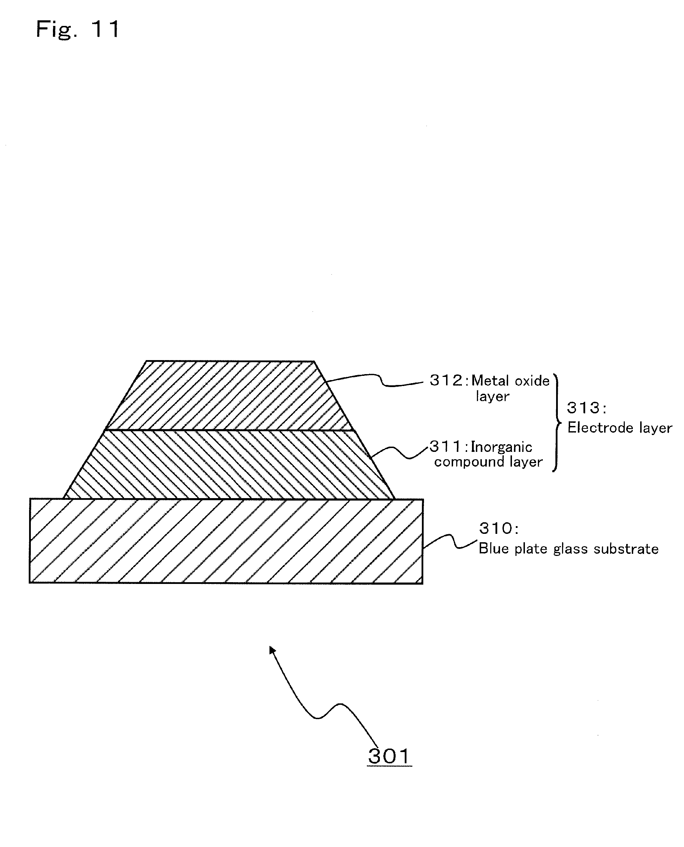

The metal oxide layer 312 provided on the blue plate glass substrate 310 was subjected to etching with an aqueous oxalic acid solution (3.5 wt%) at 30°C. Next, the inorganic compound layer 311 was subjected to etching with an etchant containing phosphoric acid (30 wt%), nitric acid (1.5 wt%), and acetic acid (40 wt%) at 30°C. In this way, a reflective electrode substrate 301 shown in Fig. 11 was obtained.

The etched surface of the inorganic compound layer 311 and the etched surface of the metal oxide layer 312 were observed with a scanning electron microscope ("S800" manufactured by Hitachi Ltd.). As a result, no residue was left on the etched surfaces and the etched surfaces were smooth with no steps. Further, the inorganic compound layer 311 and the metal oxide layer 312 were well etched in accordance with the pattern of the resist mask 314 (see Table 3-1).

### (Examples 3-2 to 3-14)

### (a) Formation of metal oxide layer and measurement of work function and specific resistance

(1) Formation of metal oxide layer
   A metal oxide layer 312 was formed on a blue plate glass substrate 310 in the same manner as in Example 3-1 (a) (1) except that the indium oxide-zinc oxide-cerium oxide target ([In] : [Zn] : [Ce] = 80.7: 14.4: 4.9 atomic %) used for sputtering the metal oxide layer 312 was changed to a target shown in Table 3-1.
   As shown in Table 3-1, targets used in Examples 3-2 to 3-14 are different from each other in composition. The composition of each of the targets used in Examples 3-2 to 3-14 is expressed in terms of atomic % in Table 3-1. Therefore, Examples 3-2 to 3-14 are different from each other in the composition of a target for use in sputtering of the metal oxide layer 312. In each of Examples 3-2 to 3-14, the physical properties of the metal oxide layer 312 were measured.
(2) Measurement of work function and specific resistance of metal oxide layer
   In the same manner as in Example 3-1 (a)(2), the metal oxide layer 312 provided on the blue plate glass substrate 310 was cleaned by the application of X rays, and then the work function and the specific resistance of the metal oxide layer were measured. The measurement results are shown in Table 3-1.

### (b) Manufacture of reflective electrode substrate, measurement of surface resistivity, and analysis of etching characteristics

(1) Manufacture of reflective electrode substrate
   In each of Examples 3-2 to 3-14, an inorganic compound layer 311 and a metal oxide layer 312 were formed on a blue plate glass substrate 310 in the same manner as in Example 3-1 (b) (1) except that the indium oxide-zinc oxide-cerium oxide target ([In]: [Zn] : [Ce] = 80.7: 14.4: 4.9 atomic %) used for sputtering the metal oxide layer 312 was changed to a target with the composition shown in Table 3-1 (see Fig. 10(3)). In this way, an electrode layer 313 composed of the inorganic compound layer 311 and the metal oxide layer 312 was formed on the blue plate glass substrate 310 to obtain a reflective electrode substrate 301.
(2) Measurement of surface resistivity
   The surface resistivity of each of the reflective electrode substrates 301 of Examples 3-2 to 3-14 was measured with a surface resistivity meter similar to the resistivity meter used in Example 3-1. All the reflective electrode substrates 301 of Examples 3-2 to 3-14 had a surface resistivity of 1.2 Ω/□.
(3) Analysis of etching characteristics
   In each of Examples 3-2 to 3-14, a resist mask 314 was formed on the metal oxide layer 312 of the reflective electrode substrate 301 in the same manner as in Example 3-1 (b) (3) (see Fig. 10(4)). Then, the inorganic compound layer 311 and the metal oxide layer 312 were subjected to etching in the same manner as in Example 3-1(b)(3) to obtain a reflective electrode substrate 301 as shown in Fig. 11.

The etched surface of the inorganic compound layer 311 and the etched surface of the metal oxide layer 312 were observed with the same scanning electron microscope as used in Example 3-1. As a result, in all the reflective electrode substrates of Examples 3-2 to 3-14, no residue was left on the etched surfaces , and the etched surfaces were smooth with no steps. Further, the inorganic compound layer 311 and the metal oxide layer 312 were well etched in accordance with the pattern of the resist mask 314 (see Table 3-1).

**Table 3-1**

| Examples | **Composition of target** | | | | Characteristics of thin film | | Etched surface condition |
|---|---|---|---|---|---|---|---|
| | Inorganic compound layer | Metal oxide layer | | | Work function (eV) | Specific resistance (µΩcm) | |
| | [Ag] (atomic %) | [In] (atomic %) | [Zn]or[Sn] (atomic %) | Third ingredient (atomic %) | | | |
| 3-1 | 100 | 80.7 | [Zn] (14.4) | [Ce] (4.9) | 5.92 | 960 | Good |
| 3-2 | 100 | 74.0 | [Zn](11.5) | [Pr] (14.5) | 5.88 | 860 | Good |
| 3-3 | 100 | 84.1 | [Zn] (14.8) | [Nd] (1.1) | 5.61 | 650 | Good |
| 3-4 | 100 | 81.6 | [Zn] (14.7) | [Sm] (3.7) | 5.74 | 480 | Good |
| 3-5 | 100 | 82.5 | [Zn] (14.9) | [Eu] (2.6) | 5.68 | 780 | Good |
| 3-6 | 100 | 84.3 | [Zn] (14.5) | [Gd] (1.2) | 5.60 | 530 | Good |
| 3-7 | 100 | 79.0 | [Zn] (14.8) | [Tb] (6.7) | 5.68 | 1950 | Good |
| 3-8 | 100 | 71.1 | [Zn] (15.0) | [Dy] (13.9) | 5.58 | 980 | Good |
| 3-9 | 100 | 78.2 | [Zn] (15.2) | [Ho] (6.6) | 5.56 | 475 | Good |
| 3-10 | 100 | 78.0 | [Zn] (16.7) | [Er] (5.3) | 5.48 | 460 | Good |
| 3-11 | 100 | 77.0 | [Zn] (17.7) | [Tm] (5.3) | 5.28 | 420 | Good |
| 3-12 | 100 | 79.8 | [Zn] (16.8) | [Yb] (3.4) | 5.84 | 455 | Good |
| 3-13 | 100 | 82.5 | [Zn] (14.7) | [Lu] (2.8) | 5.28 | 415 | Good |
| 3-14 | 100 | 85.0 | [Sn] (10.0) | [Ce] (5.0) | 5.88 | 780 | Good |

### (Example 3-15)

### (a) Manufacture of reflective electrode substrate and analysis of etching characteristics

(1) Manufacture of reflective electrode substrate
   An inorganic compound layer 311 and a metal oxide layer 312 were formed on a blue plate glass substrate 310 in the same manner as in Example 3-1 (b)(1) except that the Ag target (Ag: 100 atomic %) used for sputtering the inorganic compound layer 311 was changed to an Ag-Au-Pd target ([Ag] : [Au] : [Pd] = 98.5: 1 . 0 : 0.5 atomic %). In this way, an electrode layer 313 composed of the inorganic compound layer 311 and the metal oxide layer 312 was formed on the blue plate glass substrate 310 to obtain a reflective electrode substrate 301 (see Fig. 10(3)).
(2) Analysis of etching characteristics
   A resist mask 314 was formed on the metal oxide layer 312 of the reflective electrode substrate 301 in the same manner as in Example 3-1 (b) (3) (see Fig. 10(4)). Then, the inorganic compound layer 311 and the metal oxide layer 312 were subjected to etching in the same manner as in Example 3-1 (b) (3) to obtain a reflective electrode substrate 301 as shown in Fig. 11.

The etched surface of the inorganic compound layer 311 and the etched surface of the metal oxide layer 312 were observed with the same scanning electron microscope as used in Example 3-1. As a result, no residue was left on the etched surfaces, and the etched surfaces were smooth with no steps. Further, the inorganic compound layer 311 and the metal oxide layer 312 were well etched in accordance with the pattern of the resist mask 314.

### (Example 3-16)

### (a) Manufacture of reflective electrode substrate and analysis of etching characteristics

(1) Manufacture of reflective electrode substrate
   An inorganic compound layer 311 and a metal oxide layer 312 were formed on a blue plate glass substrate 310 in the same manner as in Example 3-1 (b) (1) except that the Ag target (Ag: 100 atomic %) used for sputtering the inorganic compound layer 311 was changed to an Ag-Au-Cu target ([Ag]: [Au] : [Cu] = 98.5: 1.0: 0.5 atomic %). In this way, an electrode layer 313 composed of the inorganic compound layer 311 and the metal oxide layer 312 was formed on the blue plate glass substrate 310 to obtain a reflective electrode substrate 301 (see Fig. 10(3)).
(2) Analysis of etching characteristics
   A resist mask 314 was formed on the metal oxide layer 312 of the reflective electrode substrate 301 in the same manner as in Example 3-1 (b)(3) (see Fig. 10(4)). Then, the inorganic compound layer 311 and the metal oxide layer 312 were subjected to etching in the same manner as in Example 3-1 (b) (3) to obtain a reflective electrode substrate 301 as shown in Fig. 11.

The etched surface of the inorganic compound layer 311 and the etched surface of the metal oxide layer 312 were observed with the same scanning electron microscope as used in Example 3-1. As a result, no residue was left on the etched surfaces, and the etched surfaces were smooth with no steps. Further, the inorganic compound layer 311 and the metal oxide layer 312 were well etched in accordance with the pattern of the resist mask 314.

### (Example 3-17)

### (a) Manufacture of reflective electrode substrate and analysis of etching characteristics

(1) Manufacture of reflective electrode substrate
   An inorganic compound layer 311 and a metal oxide layer 312 were formed on a blue plate glass substrate 310 in the same manner as in Example 3-1 (b) (1) except that the Ag target (Ag: 100 atomic %) used for sputtering the inorganic compound layer 311 was changed to anAg-Nd target ([Ag] : [Nd] = 99.0: 1.0 atomic%). In this way, an electrode layer 313 composed of the inorganic compound layer 311 and the metal oxide layer 312 was formed on the blue plate glass substrate 310 to obtain a reflective electrode substrate 301 (see Fig. 10(3)).
(2) Analysis of etching characteristics
   A resist mask 314 was formed on the metal oxide layer 312 of the reflective electrode substrate 301 in the same manner as in Example 3-1 (b)(3) (see Fig. 10(4)). Then, the inorganic compound layer 311 and the metal oxide layer 312 were subjected to etching in the same manner as in Example 3-1 (b) (3) to obtain a reflective electrode substrate 301 as shown in Fig. 11.

The etched surface of the inorganic compound layer 311 and the etched surface of the metal oxide layer 312 were observed with the same scanning electron microscope as used in Example 3-1. As a result, no residue was left on the etched surfaces, and the etched surfaces were smooth with no steps. Further, the inorganic compound layer 311 and the metal oxide layer 312 were well etched in accordance with the pattern of the resist mask 314.

### (Example 3-18)

### (a) Manufacture of reflective electrode substrate and analysis of etching characteristics

(1) Manufacture of reflective electrode substrate
   An inorganic compound layer 311 and a metal oxide layer 312 were formed on a blue plate glass substrate 310 in the same manner as in Example 3-1 (b) (1) except that the Ag target (Ag: 100 atomic %) used for sputtering of the inorganic compound layer 311 was changed to an Ag-Zr-Ni-Co target ([Ag]: [Zr] : [Ni] : [Co] = 96.0: 1.0: 1.5: 1.5 atomic %). In this way, an electrode layer 313 composed of the inorganic compound layer 311 and the metal oxide layer 312 was formed on the blue plate glass substrate 310 to obtain a reflective electrode substrate 301 (see Fig. 10(3)).
(2) Analysis of etching characteristics
   A resist mask 314 was formed on the metal oxide layer 312 of the reflective electrode substrate 301 in the same manner as in Example 3-1 (b) (3) (see Fig. 10(4)). Then, the inorganic compound layer 311 and the metal oxide layer 312 were subjected to etching in the same manner as in Example 3-1 (b) (3) to obtain a reflective electrode substrate 301 as shown in Fig. 11.

The etched surface of the inorganic compound layer 311 and the etched surface of the metal oxide layer 312 were observed with the same scanning electron microscope as used in Example 3-1. As a result, no residue was left on the etched surfaces, and the etched surfaces were smooth with no steps. Further, the inorganic compound layer 311 and the metal oxide layer 312 were well etched in accordance with the pattern of the resist mask 314.

### (Comparative Example 3-1)

### (a) Formation of metal oxide layer and measurement of work function and specific resistance

(1) Formation of metal oxide layer
   A metal oxide layer 312 was formed on a blue plate glass substrate 310 in the same manner as in Example 3-1 (a) (1) except thattheindiumoxide-zincoxide-ceriumoxidetarget ([In]: [Zn] : [Ce] = 80.7: 14.4: 4.9 atomic %) used for sputtering the metal oxide layer 312 was changed to an indium oxide-tin oxide target ([In]: [Sn] = 90.0: 10.0 atomic %) (see Table 3-2).
(2) Measurement of work function and specific resistance of metal oxide layer
   In the same manner as in Example 3-1 (a)(2), the metal oxide layer 312 provided on the blue plate glass substrate 310 was cleaned with X rays to measure the work function and the specific resistance of the metal oxide layer 312. As a result, the work function and the specific resistance of the metal oxide layer 312 were 5.12 eV and 210 µΩ·cm, respectively (see table 3-2).

### (b) Manufacture of reflective electrode substrate and analysis of etching characteristics

(1) Manufacture of reflective electrode substrate
   An inorganic compound layer 311 and a metal oxide layer 312 were formed on a blue plate glass substrate 310 as shown in Fig. 10 (3) in the same manner as in Example 3-1 (b) (1) except that the indium oxide-zinc oxide-cerium oxide target ([In]:[Zn]: [Ce] = 80.7: 14.4: 4.9 atomic %) used for sputtering the metal oxide layer 312 was changed to an indium oxide-tin oxide target ([In]: [Sn] = 90.0: 10.0 atomic %) (see Table 3-2). In this way, an electrode layer 313 composed of the inorganic compound layer 311 and the metal oxide layer 312 was formed on the blue plate glass substrate 310 to obtain a reflective electrode substrate 301 (see Fig. 10(3)).
(2) Analysis of etching characteristics
   A resist mask 314 was formed on the metal oxide layer 312 of the reflective electrode substrate 301 in the same manner as in Example 3-1 (b) (3) (see Fig. 10(4)). Then, the inorganic compound layer 311 and the metal oxide layer 312 were subjected to etching in the same manner as in Example 3-1 (b) (3) to obtain a reflective electrode substrate 301 as shown in Fig. 11.

Next, the metal oxide layer 312 was subjected to etching with an aqueous oxalic acid solution (3.5 wt%) in the same manner as in Example 3-1 (b)(3), but the metal oxide layer was not dissolved (see Table 3-2).

**Table 3-2**

| Comparative Example | Composition of target | | | | Characteristics of thin film | | Etched surface condition |
|---|---|---|---|---|---|---|---|
| | Inorganic compound layer | Metal oxide layer | | | Work function (eV) | Specific resistance (µΩcm) | |
| | [Ag] (atomic%) | [In] (atomic%) | [Zn]r[Sn] (atomic%) | Third ingredient (atomic%) | | | |
| 3-1 | 100 | 90.0 | [Sn](10. 0) | - | 5.12 | 210 | The metal oxide layer could not be etched. |

As described above, according to the manufacturing method of Comparative Example 3-1, it is difficult to carry out etching without producing a step at the boundary between the metal oxide layer and the inorganic compound layer. Therefore, it can be considered that it is also difficult to manufacture a reflective electrode substrate having a low specific resistance and a high work function by the manufacturing method according to Comparative Example 3-1. It is to be noted that all of the electrode layers of Examples 3-1 to 3-18 had a high reflectivity.

### (Summary of the third embodiment)

As described above, the reflective electrode substrate according to the third embodiment has a low specific resistance and a high work function because the inorganic compound layer contains at least Ag and the metal oxide layer contains at least indium oxide and a lanthanoid group oxide. Further, according to the manufacturing method of the present invention, the metal oxide layer is etched with an etchant containing oxalic acid and the inorganic compound layer is etched with an etchant containing phosphoric acid, nitric acid, and acetic acid. By subjecting the metal oxide layer and the inorganic compound layer to etching in such a manner, it is possible to manufacture a reflective electrode substrate having substantially no step at the boundary between the metal oxide layer and the inorganic compound layer and having little residue on the etched surface.

## Claims

1. A method for manufacturing a semi-transparent semi-reflective electrode substrate in which a metal oxide layer composed of at least indium oxide and an inorganic compound layer composed of at least Al or Ag are stacked in order of mention, the method comprising the steps of:
subjecting the inorganic compound layer to etching with an etchant λ containing phosphoric acid, nitric acid, and acetic acid; and
subjecting the metal oxide layer to etching with an etchant σ containing oxalic acid.

2. The method for manufacturing a semi-transparent semi-reflective electrode substrate according to claim 1, wherein when the etching rate of the metal oxide layer with the etchant λ is defined as A and the etching rate of the inorganic compound layer with the etchant λ is defined as B, the ratio B/A is 10 or more.

3. The method for manufacturing a semi-transparent semi-reflective electrode substrate according to claim 1 or 2, wherein the etchant λ contains 30 to 60 wt% of phosphate ions, 1 to 5 wt% of nitrate ions, and 30 to 50 wt% of acetate ions.

4. The method for manufacturing a semi-transparent semi-reflective electrode substrate according to any one of claims 1 to 3, wherein the metal oxide layer contains a lanthanoid group metal oxide.

5. The method for manufacturing a semi-transparent semi-reflective electrode substrate according to claim 4, wherein the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.

6. The method for manufacturing a semi-transparent semi-reflective electrode substrate according to claim 4 or 5, wherein the ratio of the lanthanoid group metal oxide contained in the metal oxide layer is 0.1 atomic % or more but less than 10 atomic % with respect to the total metal atoms of the metal oxides.

7. The method for manufacturing a semi-transparent semi-reflective electrode substrate according to any one of claims 1 to 6, wherein the inorganic compound layer contains 0.1 to 3 wt% of at least one metal selected from among Au, Pt, and Nd.

8. A method for manufacturing a semi-transparent semi-reflective electrode substrate in which a first metal oxide layer composed of at least indium oxide, an inorganic compound layer composed of at least Al or Ag, and a second metal oxide layer composed of at least indium oxide or zinc oxide are stacked in order of mention, the method comprising the steps of:
subjecting the second metal oxide layer and the inorganic compound layer to etching with an etchant λ containing phosphoric acid, nitric acid, and acetic acid; and
subjecting the first metal oxide layer to etching with an etchant σ containing oxalic acid.

9. The method for manufacturing a semi-transparent semi-reflective electrode substrate according to claim 8, wherein when the etching rate of the first metal oxide layer with the etchant λ is defined as A and the etching rate of the inorganic compound layer with the etchant λ is defined as B, the ratio B/A is 10 or more, and wherein when the etching rate of the inorganic compound layer with the etchant λ is defined as C and the etching rate of the second metal oxide layer with the etchant λ is defined as D, the ratio C/D is in the range of 0.5 to 2.0.

10. The method for manufacturing a semi-transparent semi-reflective electrode substrate according to claim 8 or 9, wherein the etchant λ contains 30 to 60 wt% of phosphate ions, 1 to 5 wt% of nitrate ions, and 30 to 50 wt% of acetate ions.

11. The method for manufacturing a semi-transparent semi-reflective electrode substrate according to any one of claims 8 to 10, wherein the first metal oxide layer contains a lanthanoid group metal oxide.

12. The method for manufacturing a semi-transparent semi-reflective electrode substrate according to claim 11, wherein the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.

13. The method for manufacturing a semi-transparent semi-reflective electrode substrate according to claim 11 or 12, wherein the ratio of the lanthanoid group metal oxide contained in the metal oxide layer is 0.1 atomic % or more but less than 10 atomic % with respect to the total metal atoms of the metal oxides.

14. The method for manufacturing a semi-transparent semi-reflective electrode substrate according to any one of claims 8 to 13, wherein the inorganic compound layer contains 0.1 to 3 wt% of at least one metal selected from among Au, Pt, and Nd.

15. A reflective electrode substrate comprising:
a substrate;
an inorganic compound layer composed of at least Al; and
a metal oxide layer composed of at least indium oxide, wherein the inorganic compound layer and the metal oxide layer are stacked on the substrate in order of mention.

16. The reflective electrode substrate according to claim 15, wherein the metal oxide layer contains zinc oxide, and wherein [In] / ([In]+[Zn]) is 0.7 to 0.95 (where [In] and [Zn] represent the number of indium atoms and the number of zinc atoms in the metal oxide layer, respectively).

17. The reflective electrode substrate according to claim 15 or 16, wherein the inorganic compound layer contains 0.1 to 3 wt% of at least one metal selected from among Au, Pt, and Nd.

18. The reflective electrode substrate according to any one of claims 15 to 17, wherein the metal oxide layer contains a lanthanoid group metal oxide.

19. The reflective electrode substrate according to claim 18, wherein the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.

20. The reflective electrode substrate according to claim 18 or 19, wherein the ratio of the lanthanoid group metal oxide contained in the metal oxide layer is 0.1 to 10 atomic % with respect to the total metal atoms of the metal oxides.

21. The reflective electrode substrate according to any one of claims 15 to 20, wherein the work function of the metal oxide layer is 5.6 eV or more.

22. A method for manufacturing the reflective electrode substrate according to any one of claims 15 to 21, comprising the step of subjecting the metal oxide layer and the inorganic compound layer to batch etching with an etchant containing phosphoric acid, nitric acid, and acetic acid.

23. The method for manufacturing a reflective electrode substrate according to claim 22, wherein when the etching rate of the inorganic compound layer with the etchant is defined as A and the etching rate of the metal oxide layer with the etchant is defined as B, the ratio B/A is in the range of 0.5 to 2.0.

24. The method for manufacturing a reflective electrode substrate according to claim 22 or 23, wherein the etchant contains 30 to 60 wt% of phosphoric acid, 1 to 5 wt% of nitric acid, and 30 to 50 wt% of acetic acid.

25. An etchant to be used for the step of batch etching according to claim 22, comprising an etching composition containing 30 to 60 wt% of phosphoric acid, 1 to 5 wt% of nitric acid, and 30 to 50 wt% of acetic acid.

26. A reflective electrode substrate comprising:
a substrate;
an inorganic compound layer composed of at least Ag; and
a metal oxide layer composed of at least indium oxide and a lanthanoid group metal oxide, wherein the inorganic compound layer and the metal oxide layer are stacked on the substrate in order of mention.

27. The reflective electrode substrate according to claim 26, wherein the lanthanoid group metal oxide contains at least one metal oxide selected from the group consisting of cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, and lutetium oxide.

28. The reflective electrode substrate according to claim 26 or 27, wherein the ratio of the lanthanoid group metal atoms contained in the metal oxide layer is 0.1 to 20 atomic % with respect to the total metal atoms of the metal oxides.

29. The reflective electrode substrate according to any one of claims 26 to 28, wherein the metal oxide layer contains zinc oxide, and wherein [In] / ([In]+[Zn]) is 0.7 to 0. 95 (where [In] and [Zn] represent the number of indium atoms and the number of zinc atoms in the metal oxide layer, respectively).

30. The reflective electrode substrate according to any one of claims 26 to 2 9, wherein [In] / ([In]+[Sn]) is 0.7 to 0. 97 (where [Sn] represents the number of tin atoms in the metal oxide layer) .

31. The reflective electrode substrate according to any one of claims 26 or 30, wherein the inorganic compound layer contains 0.1 to 3 wt% of at least one metal selected from among Au, Cu, Pd, Zr, Ni, Co, and Nd.

32. The reflective electrode substrate according to any one of claims 26 to 31, wherein the work function of the metal oxide layer is 5.25 eV or more.

33. A method for manufacturing the reflective electrode substrate according to any one of claims 26 to 32, comprising the steps of:
subjecting the metal oxide layer to etching with an etchant containing oxalic acid; and
subjecting the inorganic compound layer to etching with an etchant containing phosphoric acid, nitric acid, and acetic acid.

34. The method for manufacturing a reflective electrode substrate according to claim 33, wherein the etchant to be used for etching of the inorganic compound layer contains 30 to 60 wt% of phosphoric acid, 1 to 5 wt% of nitric acid, and 30 to 50 wt% of acetic acid.
